# EUROPEAN PATENT APPLICATION

(11) **EP 4 404 459 A1**
(43) Date of publication of application: **24.07.2024**
(21) Application number: 22869033.5
(22) Date of filing: 31.08.2022
(51) Int. Cl.: H03H 9/25, H03H 9/64

(54) **SURFACE ACOUSTIC WAVE RESONANCE DEVICE AND METHOD FOR FORMING SAME, FILTER DEVICE, AND RADIO FREQUENCY FRONT END DEVICE**

(30) Priority: 14.09.2021 CN 202111075400
(71) Applicant: Changzhou Chemsemi Co., Ltd., Changzhou, Jiangsu 213166 (CN)
(72) Inventor: ZOU, Yali, Changzhou, Jiangsu 213166 (CN)
(74) Representative: Piticco, Lorena
(86) International application number: PCT/CN2022/116061
(87) International publication number: WO 2023/040661

(57) **Abstract**

A SAW resonant device, comprising: a piezoelectric substrate; an electrode layer which is arranged on the piezoelectric substrate and comprises an IDT, where the IDT comprises a first bus, multiple first electrode strips, a second bus and multiple second electrode strips, first ends of the multiple first electrode strips are connected to the first bus, second ends of the multiple first electrode strips that are opposite to the first ends are close to the second bus, a first gap is provided between the second ends and the second bus, third ends of the multiple second electrode strips are connected to the second bus, fourth ends of the multiple second electrode strips that are opposite to the third ends are close to the first bus, and a second gap is provided between the fourth ends and the first bus; a first load layer which is arranged above the fourth ends and close to the first ends and the second gap; a first dielectric layer which is arranged above the electrode layer and covers the first load layer; and a second load layer which is arranged on the first dielectric layer, above the second ends and close to the third ends and the first gap. The SAW resonant device can suppress lateral parasitic resonance and reduce split parasitic resonance introduced into a passband of a filter device from the load layers.

## Description

### CROSS-REFERENCE TO RELATED APPLICATIONS

This application claims the benefit of priority to Chinese patent application No. 202111075400.5, filed on September 14, 2021, entitled "SURFACE ACOUSTIC WAVE RESONANCE DEVICE AND METHOD FOR FORMING SAME, FILTER DEVICE, AND RADIO FREQUENCY FRONT END DEVICE", the entire disclosures of which are incorporated herein by reference.

### TECHNICAL FIELD

The present disclosure relates to the technical field of semiconductors, and more particularly to a surface acoustic wave resonance device and a method for forming the same, a filter device and a radio frequency front-end device.

### BACKGROUND

A Radio Frequency (RF) front-end chip of a wireless communication device includes a Power Amplifier (PA), an antenna switch, a radio frequency filter, a multiplexer including a diplexer, and a Low Noise Amplifier (LNA), etc. The radio frequency filter includes a Surface Acoustic Wave (SAW) filter, a Bulk Acoustic Wave (BAW) filter, a Micro-Electro-Mechanical System (MEMS) filter, and an Integrated Passive Device (IPD) filter, etc.

As both a SAW resonator and a BAW resonator have a high quality value (Q value), a radio frequency filter including either a SAW resonator, namely a SAW filter, or a BAW resonator, namely a BAW filter, has low insertion loss and high out-band rejection, and thus become a mainstream radio frequency filter applied to wireless communication devices such as mobile phones and base stations. The Q value is a quality factor value of a resonator, and is defined by a center frequency divided by 3 dB bandwidth of the resonator. An effective frequency of a SAW filter typically ranges from 0.4 GHz to 2.7 GHz.

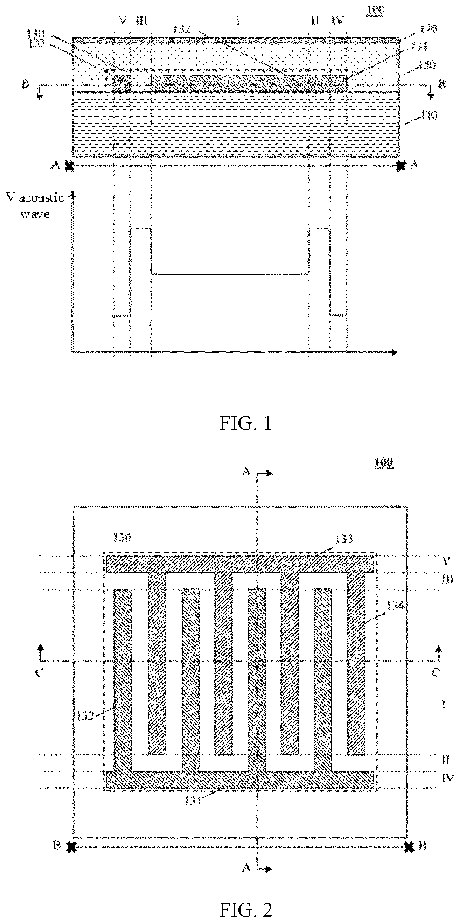

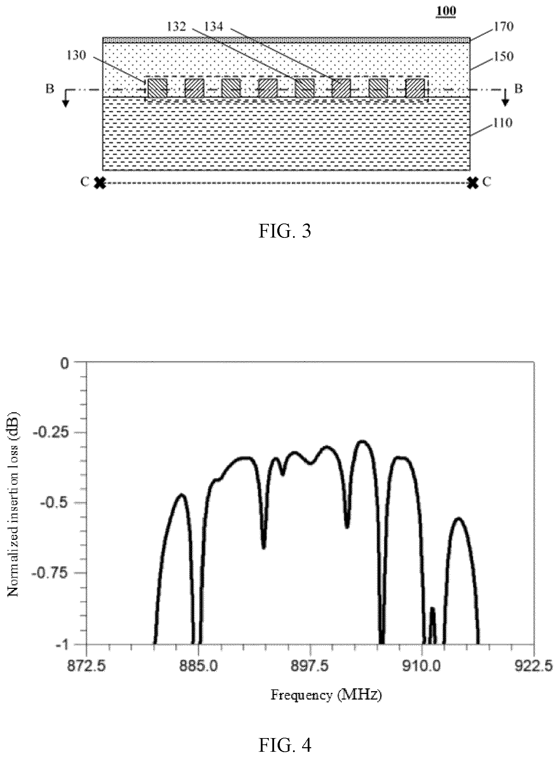

FIG. 1 illustrates a schematic view of a first cross-section of a SAW resonator 100, FIG. 2 illustrates a schematic view of a top plane of the SAW resonator 100 corresponding to the first cross-section, and FIG. 3 illustrates a schematic view of a second cross-section of the SAW resonator 100.

FIG. 1 illustrates a schematic view of a cross-section A of the SAW resonator 100 and corresponding wave velocity. The SAW resonator 100 includes a piezoelectric substrate 110, an electrode layer 130, a temperature compensation layer 150 and a frequency trimming layer 170. The electrode layer 130 is disposed on the piezoelectric substrate 110 along a first direction. The electrode layer 130 includes an Interdigital Transducer (IDT). The interdigital transducer includes a first busbar 131, multiple first electrode strips 132 and a second busbar 133. A first end of each of first electrode strips 132 is coupled with the first busbar 131, and a second end of each of the first electrode strips 132 opposite to the first end along a second direction is close to the second busbar 133. The first direction is orthogonal to the second direction. A first gap is disposed between the second end and the second busbar 133. The temperature compensation layer 150 is disposed on the piezoelectric substrate 110 and covers the electrode layer130. The frequency trimming layer 170 is disposed on the temperature compensation layer 150. It should be noted that the temperature compensation layer has a temperature frequency shift characteristic opposite to that of the piezoelectric substrate, which can adjust a Temperature Coefficient of Frequency (TCF) to trend towards 0 ppm/°C, so as to improve the characteristic that an operating frequency of the SAW filter shifts with rise of an operating temperature, resulting in a higher frequency temperature stability. The SAW resonator, including the temperature compensation layer, is called a Temperature-Compensated SAW resonator (i.e., a TC-SAW resonator).

FIG. 2 illustrates a schematic view of a top plane B of the SAW resonator 100 corresponding to the cross-section A. As shown in FIG. 2, the electrode layer 130 further includes multiple second electrode strips 134. A third end of each of the second electrode strips 134 is coupled with the second busbar 133, a fourth end of each of the second electrode strips 134 opposite to the third end along the second direction is close to the first busbar 131, and a second gap is disposed between the fourth end and the first busbar 131. The first electrode strips 132 and the second electrode strips 134 are arranged alternately to each other between the first busbar 131 and the second busbar 133, as shown in FIG. 3. FIG.3 illustrates a schematic view of a cross-section C of the SAW resonator 100. Two adjacent electrode strips are respectively coupled with the first busbar 131 and the second busbar 133. An overlap region between the first electrode strips 132 and the second electrode strips 134 constitutes a first region I. A region between the first region I and the first busbar 131 constitutes a second region II. A region between the first region I and the second busbar 133 constitutes a third region III. A region where the first busbar 131 is located constitutes a fourth region IV The second region II is disposed between the first region I and the fourth region IV A region where the second busbar 133 is located constitutes a fifth region V The third region III is disposed between the first region I and the fifth region V

Referring to the schematic view of the wave velocity in FIG. 1, the wave velocity in the first region I is lower than that in the second region II, the wave velocity in the first region I is also lower than that in the third region III, and the wave velocity in the second region II is equal to or approximate to that in the third region III. A high-order acoustic wave energy is generated in the first region I, which results in a transverse spurious resonance. FIG. 4 illustrates a passband portion of a normalized insertion loss curve of a filter corresponding to the SAW resonator 100. The passband portion includes a significant amount of ripples generated by the transverse spurious resonance, which can increase the insertion loss of the filter. It should be noted that the term "approximate to" in the description means that a difference between two objects is relatively small and falls within a normal range of error.

### SUMMARY

An embodiment of the present disclosure is to provide a surface acoustic wave resonance device, which can suppress a transverse spurious resonance in a high-order mode, and mitigate a split mode to reduce a spurious resonance in a passband of a filter device produced by a load layer.

An embodiment of the present disclosure provides a surface acoustic wave resonance device. The surface acoustic wave resonance device includes a piezoelectric substrate, an electrode layer, a first load layer, a first dielectric layer and a second load layer. The electrode layer is disposed on the piezoelectric substrate along a first direction, and the electrode layer includes an interdigital transducing device. The interdigital transducing device includes a first busbar, multiple first electrode strips, a second busbar and multiple second electrode strips. A first end of each of the first electrode strips is coupled with the first busbar, a second end of each of the first electrode strips opposite to the first end along a second direction is close to the second busbar, and a first gap is disposed between the second end and the second busbar. A third end of each of the second electrode strips is coupled with the second busbar, a fourth end of each of the second electrode strips opposite to the third end along the second direction is close to the first busbar, and a second gap is disposed between the fourth end and the first busbar. The first direction is orthogonal to the second direction. The first load layer is disposed above the fourth end along the first direction and close to the first end and the second gap along the second direction. The first load layer intersects with the first electrode strips to form multiple first overlap portions, and the first end is disposed between the first busbar and the first overlap portions. The first load layer also intersects with the second electrode strips to form multiple second overlap portions, and the second overlap portions are close to the second gap. The first dielectric layer is disposed above the electrode layer along the first direction and covers the first load layer. The second load layer is disposed on the first dielectric layer and above the second end along the first direction and disposed close to the third end and the first gap along the second direction. The second load layer intersects with the first electrode strips to form multiple third overlap portions, and the third overlap portions are close to the first gap. The second load layer also intersects with the second electrode strips to form multiple fourth overlap portions, and the third end is disposed between the second busbar and the fourth overlap portions.

According to some embodiments, the surface acoustic wave resonance device further includes a second dielectric layer disposed on the piezoelectric substrate along the first direction and covering the electrode layer. The second dielectric layer includes the first dielectric layer, the first load layer is disposed in the second dielectric layer, and the second load layer is disposed in the second dielectric layer. According to some embodiments, the first dielectric layer is made of a material selected from a group consisting of silicon dioxide and silicon oxyfluoride. According to some embodiments, the second dielectric layer is made of a material selected from a group consisting of silicon dioxide and silicon oxyfluoride. According to some embodiments, the surface acoustic wave resonance device further includes a third dielectric layer disposed on the second dielectric layer corresponding to the electrode layer. According to some embodiments, the third dielectric layer is made of a material selected from a group consisting of silicon nitride, aluminum nitride, silicon oxynitride, aluminum oxide and silicon carbide.

According to some embodiments, the surface acoustic wave resonance device further includes a fourth dielectric layer disposed on the piezoelectric substrate along the first direction and covering the electrode layer. The first load layer is disposed on the fourth dielectric layer, and the first dielectric layer is disposed on the fourth dielectric layer corresponding to the electrode layer. According to some embodiments, the fourth dielectric layer is made of a material selected from a group consisting of silicon dioxide and silicon oxyfluoride. According to some embodiments, the first dielectric layer is made of a material selected from a group consisting of silicon nitride, aluminum nitride, silicon oxynitride, aluminum oxide and silicon carbide.

According to some embodiments, the first load layer is made of a material selected from a group consisting of molybdenum, ruthenium, tungsten, platinum, iridium, aluminum, beryllium, gold, titanium, copper, chromium, magnesium and scandium. According to some embodiments, the first load layer includes a first load sublayer and a second load sublayer disposed on the first load sublayer, and a material of the first load sublayer is different from a material of the second load sublayer.

According to some embodiments, the second load layer is made of a material selected from a group consisting of molybdenum, ruthenium, tungsten, platinum, iridium, aluminum, beryllium, gold, titanium, copper, chromium, magnesium and scandium. According to some embodiments, the second load layer includes a third load sublayer and a fourth load sublayer disposed on the third load sublayer, and a material of the third load sublayer is different from a material of the fourth load sublayer.

According to some embodiments, a first thickness of the first load layer is different from a second thickness of the second load layer.

According to some embodiments, a first width of the first load layer is different from a second width of the second load layer.

According to some embodiments, the first load layer includes multiple first load portions, and the second load layer includes multiple second load portions.

According to some embodiments, the first load layer is in a strip shape, and the second load layer is in a strip shape.

According to some embodiments, along the second direction, a first region is disposed between the first load layer and the second load layer, a second region is disposed between the first load layer and the first busbar, a third region is disposed between the second load layer and the second busbar, a fourth region is disposed between the first region and the second region, and a fifth region is disposed between the first region and the third region. The fourth region includes the first load layer, and the fifth region includes the second load layer. A first wave velocity of an acoustic wave in the first region is greater than a second wave velocity of the acoustic wave in the fourth region, and is also greater than a third wave velocity of the acoustic wave in the fifth region, and the second wave velocity is different from the third wave velocity.

It should be noted that the region between the first load layer and the second load layer of the SAW resonance device constitutes the first region, the region where the first load layer is located constitutes the second region at a first side of the first region, and the region where the second load layer is located constitutes the third region at a second side of the first region opposite to the first side. The first load layer and the second load layer are configured to reduce a propagation speed of acoustic waves in the second region and the third region respectively to be lower than the propagation speed of the acoustic waves in the first region. In this situation, the SAW resonance device is in a piston mode, in which higher-order transverse spurious resonance is suppressed. In addition, a first setting parameter of the first load layer (such as relative height, thickness, width) is different from a second setting parameter of the second load layer, and the propagation speeds of the acoustic waves in the second region and the third region are different and corresponding resonance frequencies are different. By reasonably setting the first setting parameter and the second setting parameter, two split resonances generated by the first load layer and the second load layer respectively partially cancel out with each other, which can mitigate split mode produced by the first load layer and the second load layer, and reduce split spurious resonance in a passband of a filter device produced by the load layers.

Another embodiment of the present disclosure provides a surface acoustic wave resonance device. The surface acoustic wave resonance device includes a piezoelectric substrate, an electrode layer, a first load layer, a first dielectric layer and a second load layer. The electrode layer is disposed on the piezoelectric substrate along a first direction, and the electrode layer includes an interdigital transducing device. The interdigital transducing device includes a first busbar portion, a second busbar portion and an interdigital portion disposed between the first busbar portion and the second busbar portion along a second direction. The first direction is orthogonal to the second direction. The first load layer is disposed above the interdigital portion along the first direction and close to the first busbar portion along the second direction. The first dielectric layer is disposed above the electrode layer along the first direction and covers the first load layer. The second load layer is disposed on the first dielectric layer along the first direction and close to the second busbar portion along the second direction. A first region is disposed between the first load layer and the second load layer along the second direction, a second region is disposed between the first busbar portion and the first load layer along the second direction, a third region is disposed between the second busbar portion and the second load layer along the second direction, a fourth region is disposed between the first region and the second region along the second direction, and a fifth region is disposed between the first region and the third region along the second direction. The first load layer is disposed in the fourth region, and the second load layer is disposed in the fifth region. A first wave velocity of an acoustic wave in the first region is greater than a second wave velocity of the acoustic wave in the fourth region, and is also greater than a third wave velocity of the acoustic wave in the fifth region, and the second wave velocity is different from the third wave velocity.

According to some embodiments, the surface acoustic wave resonance device further includes a second dielectric layer disposed on the piezoelectric substrate along the first direction and covering the electrode layer. The second dielectric layer includes the first dielectric layer, the first load layer is disposed in the second dielectric layer, and the second load layer is disposed in the second dielectric layer. According to some embodiments, the first dielectric layer is made of a material selected from a group consisting of silicon dioxide and silicon oxyfluoride. According to some embodiments, the second dielectric layer is made of a material selected from a group consisting of silicon dioxide and silicon oxyfluoride. According to some embodiments, the surface acoustic wave resonance device further includes a third dielectric layer disposed on the second dielectric layer corresponding to the electrode layer. According to some embodiments, the third dielectric layer is made of a material selected from a group consisting of silicon nitride, aluminum nitride, silicon oxynitride, aluminum oxide and silicon carbide.

According to some embodiments, the surface acoustic wave resonance device further includes a fourth dielectric layer disposed on the piezoelectric substrate along the first direction and covering the electrode layer. The first load layer is disposed on the fourth dielectric layer, and the first dielectric layer is disposed on the fourth dielectric layer corresponding to the electrode layer. According to some embodiments, the fourth dielectric layer is made of a material selected from a group consisting of silicon dioxide and silicon oxyfluoride. According to some embodiments, the first dielectric layer is made of a material selected from a group consisting of silicon nitride, aluminum nitride, silicon oxynitride, aluminum oxide and silicon carbide.

According to some embodiments, the first load layer is made of a material selected from a group consisting of molybdenum, ruthenium, tungsten, platinum, iridium, aluminum, beryllium, gold, titanium, copper, chromium, magnesium and scandium.

According to some embodiments, the first load layer includes a first load sublayer and a second load sublayer disposed on the first load sublayer, and a material of the first load sublayer is different from a material of the second load sublayer.

According to some embodiments, the second load layer is made of a material selected from a group consisting of molybdenum, ruthenium, tungsten, platinum, iridium, aluminum, beryllium, gold, titanium, copper, chromium, magnesium and scandium.

According to some embodiments, the second load layer includes a third load sublayer and a fourth load sublayer disposed on the third load sublayer, and a material of the third load sublayer is different from a material of the fourth load sublayer.

According to some embodiments, a first thickness of the first load layer is different from a second thickness of the second load layer.

According to some embodiments, a first width of the first load layer is different from a second width of the second load layer.

According to some embodiments, the first load layer includes multiple first load portions, and the second load layer includes multiple second load portions.

According to some embodiments, the first load layer is in a strip shape, and the second load layer is in a strip shape.

Another embodiment of the present disclosure provides a filter device. The filter device includes at least one surface acoustic wave resonance device according to any one of preceding embodiments.

Another embodiment of the present disclosure provides a radio frequency front-end device. The radio frequency front-end device includes a power amplification device and at least one filter device according to any one of preceding embodiments, and the power amplification device is coupled with the filter device.

Another embodiment of the present disclosure provides a radio frequency front-end device. The radio frequency front-end device includes a low noise amplification device and at least one filter device according to any one of preceding embodiments, and the low noise amplification device is coupled with the filter device.

Another embodiment of the present disclosure provides a radio frequency front-end device. The radio frequency front-end device includes a multiplexing device, and the multiplexing device includes at least one filter device according to any one of preceding embodiments.

Another embodiment of the present disclosure provides a method for forming a surface acoustic wave resonance device. The method includes: providing a piezoelectric substrate, forming an electrode layer on the piezoelectric substrate along a first direction, forming a first load layer above the fourth end along the first direction and close to the first end and the second gap along the second direction, forming a first dielectric layer above the electrode layer along the first direction and covering the first load layer, and forming a second load layer on the first dielectric layer and above the second end along the first direction and close to the third end and the first gap along the second direction. Forming the electrode layer includes forming an interdigital transducing device, and the interdigital transducing device includes a first busbar, multiple first electrode strips, a second busbar and multiple second electrode strips. A first end of each of the first electrode strips is coupled with the first busbar, a second end of each of the first electrode strips opposite to the first end along a second direction is close to the second busbar, and a first gap is disposed between the second end and the second busbar. A third end of each of the second electrode strips is coupled with the second busbar, a fourth end of each of the second electrode strips opposite to the third end along the second direction is close to the first busbar, and a second gap is disposed between the fourth end and the first busbar. The first direction is orthogonal to the second direction. The first load layer intersects with the first electrode strips to form multiple first overlap portions, and the first end is disposed between the first busbar and the first overlap portions. The first load layer also intersects with the second electrode strips to form multiple second overlap portions, and the second overlap portions are close to the second gap. The second load layer intersects with the first electrode strips to form multiple third overlap portions, and the third overlap portions are close to the first gap. The second load layer also intersects with the second electrode strips to form multiple fourth overlap portions, and the third end is disposed between the second busbar and the fourth overlap portions.

According to some embodiments, the method further includes: forming a second dielectric layer on the piezoelectric substrate and covering the electrode layer. The first load layer is disposed on the second dielectric layer, and the first dielectric layer is disposed on the second dielectric layer. According to some embodiments, the first dielectric layer is made of a material selected from a group consisting of silicon nitride, aluminum nitride, silicon oxynitride, aluminum oxide and silicon carbide. According to some embodiments, the second dielectric layer is made of a material selected from a group consisting of silicon dioxide and silicon oxyfluoride. According to some embodiments, the method further includes: forming a third dielectric layer on the second dielectric layer and covering the second load layer, and forming a fourth dielectric layer on the third dielectric layer corresponding to the electrode layer. According to some embodiments, the first dielectric layer is made of a material selected from a group consisting of silicon dioxide and silicon oxyfluoride. According to some embodiments, the second dielectric layer is made of a material selected from a group consisting of silicon dioxide and silicon oxyfluoride. According to some embodiments, the third dielectric layer is made of a material selected from a group consisting of silicon dioxide and silicon oxyfluoride. According to some embodiments, the fourth dielectric layer is made of a material selected from a group consisting of silicon nitride, aluminum nitride, silicon oxynitride, aluminum oxide and silicon carbide.

According to some embodiments, forming the first load layer includes forming a first load sublayer and forming a second load sublayer on the first load sublayer, and a material of the first load sublayer is different from a material of the second load sublayer.

According to some embodiments, forming the second load layer includes forming a third load sublayer and forming a fourth load sublayer on the third load sublayer, and a material of the third load sublayer is different from a material of the fourth load sublayer.

According to some embodiments, a first thickness of the first load layer is different from a second thickness of the second load layer.

According to some embodiments, a first width of the first load layer is different from a second width of the second load layer.

According to some embodiments, the first load layer includes multiple first load portions, and the second load layer includes multiple second load portions.

According to some embodiments, the first load layer is in a strip shape, and the second load layer is in a strip shape.

According to some embodiments, along the second direction, a first region is disposed between the first load layer and the second load layer, a second region is disposed between the first load layer and the first busbar, a third region is disposed between the second load layer and the second busbar, a fourth region is disposed between the first region and the second region, and a fifth region is disposed between the first region and the third region. The fourth region includes the first load layer, and the fifth region includes the second load layer. A first wave velocity of an acoustic wave in the first region is greater than a second wave velocity of the acoustic wave in the fourth region, and is also greater than a third wave velocity of the acoustic wave in the fifth region, and the second wave velocity is different from the third wave velocity.

### BRIEF DESCRIPTION OF THE DRAWINGS

FIGS. 1 to 3 illustrate schematic views of a SAW resonator 100;
FIG. 4 illustrates a schematic view of a passband portion of a normalized insertion loss curve of a filter;
FIGS. 5 to 8 illustrate schematic views of a SAW resonance device 200 according to an embodiment of the present disclosure;
FIG. 9 illustrates a schematic view of a passband portion of a normalized insertion loss curve of two filters;
FIG. 10 illustrates a schematic view of an integrated SAW resonance device 3000 according to an embodiment of the present disclosure;
FIGS. 11 to 13 illustrate schematic views of a SAW resonance device 3200 according to an embodiment of the present disclosure;
FIG. 14 illustrates a schematic view of an integrated SAW resonance device 4000 according to an embodiment of the present disclosure;
FIGS. 15 to 17 illustrate schematic views of a SAW resonance device 4000 according to an embodiment of the present disclosure;
FIGS. 18 to 21 illustrate schematic views of a SAW resonance device 500 according to an embodiment of the present disclosure;
FIG. 22 illustrates a schematic module diagram of a wireless communication device 600;
FIG. 23 illustrates a schematic flowchart of a method for forming a SAW resonance device 700 according to an embodiment of the present disclosure;
FIGS. 24 to 26 illustrate schematic views showing a method for forming a SAW resonance device 800 according to an embodiment of the present disclosure; and
FIGS. 27 to 28 illustrate schematic views showing a method for forming a SAW resonance device 900 according to an embodiment of the present disclosure.

### DETAILED DESCRIPTION

In order to make above-mentioned purpose, feature and advantage of the present disclosure more obvious and understandable, specific embodiments of the present disclosure will be described in detail below in conjunction with the accompanying drawings.

In following description, specific details are set forth in order to provide a thorough understanding of the present disclosure, but the present disclosure may be practiced otherwise than as specifically described herein, and therefore the present disclosure is not limited by the specific embodiments disclosed below.

As mentioned above, a high-order acoustic wave energy is generated in a resonance region of a SAW resonance device, which results in a transverse spurious resonance, and a passband portion of a normalized insertion loss curve of a filter corresponding to the SAW resonator includes a significant amount of ripples generated by the transverse spurious resonance, which increases the insertion loss of the filter.

An embodiment of the present disclosure provides a surface acoustic wave resonance device. The surface acoustic wave resonance device includes a piezoelectric substrate, an electrode layer, a first load layer, a first dielectric layer and a second load layer. The electrode layer is disposed on the piezoelectric substrate along a first direction, and the electrode layer includes an interdigital transducing device. The interdigital transducing device includes a first busbar, multiple first electrode strips, a second busbar and multiple second electrode strips. A first end of each of the first electrode strips is coupled with the first busbar, a second end of each of the first electrode strips opposite to the first end along a second direction is close to the second busbar, and a first gap is disposed between the second end and the second busbar. A third end of each of the second electrode strips is coupled with the second busbar, a fourth end of each of the second electrode strips opposite to the third end along the second direction is close to the first busbar, and a second gap is disposed between the fourth end and the first busbar. The first direction is orthogonal to the second direction. The first load layer is disposed above the fourth end along the first direction and close to the first end and the second gap along the second direction. The first load layer intersects with the first electrode strips to form multiple first overlap portions, and the first end is disposed between the first busbar and the first overlap portions. The first load layer also intersects with the second electrode strips to form multiple second overlap portions, and the second overlap portions are close to the second gap. The first dielectric layer is disposed above the electrode layer along the first direction and covers the first load layer. The second load layer is disposed on the first dielectric layer and above the second end along the first direction and disposed close to the third end and the first gap along the second direction. The second load layer intersects with the first electrode strips to form multiple third overlap portions, and the third overlap portions are close to the first gap. The second load layer also intersects with the second electrode strips to form multiple fourth overlap portions, and the third end is disposed between the second busbar and the fourth overlap portions.

It has been found that a region between the first load layer and the second load layer of the SAW resonance device constitutes a first region, a region where the first load layer is located constitutes a second region at a first side of the first region, and a region where the second load layer is located constitutes a third region at a second side of the first region opposite to the first side. The first load layer and the second load layer are configured to reduce a propagation speed of acoustic waves in the second region and the third region respectively to be lower than the propagation speed of the acoustic waves in the first region. In this state, the SAW resonance device is in a piston mode, in which higher-order transverse spurious resonance is suppressed.

It has been found that a load layer will result in a split mode. In the split mode, a split spurious resonance is generated in a passband of a filter device. In the case of two load layers are provided with the same setting parameter, their split spurious resonance will be superposed, which strengthens an overall split spurious resonance in the passband of the filter device. According to the embodiments of the present disclosure, a first setting parameter of the first load layer (such as relative height, thickness, width) is different from a second setting parameter of the second load layer, and the propagation speeds of the acoustic waves in the second region and the third region are different and corresponding resonance frequencies are different. By reasonably setting the first setting parameter and the second setting parameter, two split resonances generated by the first load layer and the second load layer respectively partially cancel out with each other, which can mitigate split mode produced by the first load layer and the second load layer, and reduce split spurious resonance in the passband of the filter device produced by the load layers.

In some embodiments, the surface acoustic wave resonance device further includes a second dielectric layer disposed on the piezoelectric substrate along the first direction and covering the electrode layer. The second dielectric layer includes the first dielectric layer, the first load layer is disposed in the second dielectric layer, and the second load layer is disposed in the second dielectric layer. In some embodiments, the first dielectric layer is made of a material selected from a group consisting of silicon dioxide and silicon oxyfluoride. In some embodiments, the second dielectric layer is made of a material selected from a group consisting of silicon dioxide and silicon oxyfluoride. In some embodiments, the surface acoustic wave resonance device further includes a third dielectric layer disposed on the second dielectric layer corresponding to the electrode layer. In some embodiments, the third dielectric layer is made of a material selected from a group consisting of silicon nitride, aluminum nitride, silicon oxynitride, aluminum oxide and silicon carbide.

In some embodiments, the surface acoustic wave resonance device further includes a fourth dielectric layer disposed on the piezoelectric substrate along the first direction and covering the electrode layer. The first load layer is disposed on the fourth dielectric layer, and the first dielectric layer is disposed on the fourth dielectric layer corresponding to the electrode layer. In some embodiments, the fourth dielectric layer is made of a material selected from a group consisting of silicon dioxide and silicon oxyfluoride. In some embodiments, the first dielectric layer is made of a material selected from a group consisting of silicon nitride, aluminum nitride, silicon oxynitride, aluminum oxide and silicon carbide.

In some embodiments, the first load layer is made of a material selected from a group consisting of molybdenum, ruthenium, tungsten, platinum, iridium, aluminum, beryllium, gold, titanium, copper, chromium, magnesium and scandium. In some embodiments, the first load layer includes a first load sublayer and a second load sublayer disposed on the first load sublayer, and a material of the first load sublayer is different from a material of the second load sublayer.

In some embodiments, the second load layer is made of a material selected from a group consisting of molybdenum, ruthenium, tungsten, platinum, iridium, aluminum, beryllium, gold, titanium, copper, chromium, magnesium and scandium. In some embodiments, the second load layer includes a third load sublayer and a fourth load sublayer disposed on the third load sublayer, and a material of the third load sublayer is different from a material of the fourth load sublayer.

In some embodiments, a first thickness of the first load layer is different from a second thickness of the second load layer.

In some embodiments, a first width of the first load layer is different from a second width of the second load layer.

In some embodiments, the first load layer includes multiple first load portions, and the second load layer includes multiple second load portions.

In some embodiments, the first load layer is in a strip shape, and the second load layer is in a strip shape.

In some embodiments, along the second direction, a first region is disposed between the first load layer and the second load layer, a second region is disposed between the first load layer and the first busbar, a third region is disposed between the second load layer and the second busbar, a fourth region is disposed between the first region and the second region, and a fifth region is disposed between the first region and the third region. The fourth region includes the first load layer, and the fifth region includes the second load layer. A first wave velocity of an acoustic wave in the first region is greater than a second wave velocity of the acoustic wave in the fourth region, and is also greater than a third wave velocity of the acoustic wave in the fifth region, and the second wave velocity is different from the third wave velocity.

It should be noted that the region between the first load layer and the second load layer of the SAW resonance device constitutes the first region, the region where the first load layer is located constitutes the second region at a first side of the first region, and the region where the second load layer is located constitutes the third region at a second side of the first region opposite to the first side. The first load layer and the second load layer are configured to reduce a propagation speed of acoustic waves in the second region and the third region respectively to be lower than the propagation speed of the acoustic waves in the first region. In this state, the SAW resonance device is in a piston mode, which can suppress a higher-order transverse spurious resonance.

In addition, a first setting parameter of the first load layer (such as relative height, thickness, width) is different from a second setting parameter of the second load layer, and the propagation speeds of the acoustic waves in the second region and the third region are different and corresponding resonance frequencies are different. By reasonably setting the first setting parameter and the second setting parameter, two split resonances generated by the first load layer and the second load layer respectively partially cancel out with each other, which can mitigate split mode produced by the first load layer and the second load layer, and reduce split spurious resonance in a passband of a filter device produced by the load layers.

Another embodiment of the present disclosure provides a surface acoustic wave resonance device. The surface acoustic wave resonance device includes a piezoelectric substrate, an electrode layer, a first load layer, a first dielectric layer and a second load layer. The electrode layer is disposed on the piezoelectric substrate along a first direction, and the electrode layer includes an interdigital transducing device. The interdigital transducing device includes a first busbar portion, a second busbar portion and an interdigital portion disposed between the first busbar portion and the second busbar portion along a second direction. The first direction is orthogonal to the second direction. The first load layer is disposed above the interdigital portion along the first direction and close to the first busbar portion along the second direction. The first dielectric layer is disposed above the electrode layer along the first direction and covers the first load layer. The second load layer is disposed on the first dielectric layer along the first direction and close to the second busbar portion along the second direction. A first region is disposed between the first load layer and the second load layer along the second direction, a second region is disposed between the first busbar portion and the first load layer along the second direction, a third region is disposed between the second busbar portion and the second load layer along the second direction, a fourth region is disposed between the first region and the second region along the second direction, and a fifth region is disposed between the first region and the third region along the second direction. The first load layer is disposed in the fourth region, and the second load layer is disposed in the fifth region. A first wave velocity of an acoustic wave in the first region is greater than a second wave velocity of the acoustic wave in the fourth region, and is also greater than a third wave velocity of the acoustic wave in the fifth region, and the second wave velocity is different from the third wave velocity.

In some embodiments, the surface acoustic wave resonance device further includes a second dielectric layer disposed on the piezoelectric substrate along the first direction and covering the electrode layer. The second dielectric layer includes the first dielectric layer, the first load layer is disposed in the second dielectric layer, and the second load layer is disposed in the second dielectric layer. In some embodiments, the first dielectric layer is made of a material selected from a group consisting of silicon dioxide and silicon oxyfluoride. In some embodiments, the second dielectric layer is made of a material selected from a group consisting of silicon dioxide and silicon oxyfluoride. In some embodiments, the surface acoustic wave resonance device further includes a third dielectric layer disposed on the second dielectric layer corresponding to the electrode layer. In some embodiments, the third dielectric layer is made of a material selected from a group consisting of silicon nitride, aluminum nitride, silicon oxynitride, aluminum oxide and silicon carbide.

In some embodiments, the surface acoustic wave resonance device further includes a fourth dielectric layer disposed on the piezoelectric substrate along the first direction and covering the electrode layer. The first load layer is disposed on the fourth dielectric layer, and the first dielectric layer is disposed on the fourth dielectric layer corresponding to the electrode layer. In some embodiments, the fourth dielectric layer is made of a material selected from a group consisting of silicon dioxide and silicon oxyfluoride. In some embodiments, the first dielectric layer is made of a material selected from a group consisting of silicon nitride, aluminum nitride, silicon oxynitride, aluminum oxide and silicon carbide.

In some embodiments, the first load layer is made of a material selected from a group consisting of molybdenum, ruthenium, tungsten, platinum, iridium, aluminum, beryllium, gold, titanium, copper, chromium, magnesium and scandium.

In some embodiments, the first load layer includes a first load sublayer and a second load sublayer disposed on the first load sublayer, and a material of the first load sublayer is different from a material of the second load sublayer.

In some embodiments, the second load layer is made of a material selected from a group consisting of molybdenum, ruthenium, tungsten, platinum, iridium, aluminum, beryllium, gold, titanium, copper, chromium, magnesium and scandium.

In some embodiments, the second load layer includes a third load sublayer and a fourth load sublayer disposed on the third load sublayer, and a material of the third load sublayer is different from a material of the fourth load sublayer.

In some embodiments, a first thickness of the first load layer is different from a second thickness of the second load layer.

In some embodiments, a first width of the first load layer is different from a second width of the second load layer.

In some embodiments, the first load layer includes multiple first load portions, and the second load layer includes multiple second load portions.

In some embodiments, the first load layer is in a strip shape, and the second load layer is in a strip shape.

Another embodiment of the present disclosure provides a filter device. The filter device includes at least one surface acoustic wave resonance device according to any one of preceding embodiments.

Another embodiment of the present disclosure provides a radio frequency front-end device. The radio frequency front-end device includes a power amplification device and at least one filter device according to any one of preceding embodiments, and the power amplification device is coupled with the filter device.

Another embodiment of the present disclosure provides a radio frequency front-end device. The radio frequency front-end device includes a low noise amplification device and at least one filter device according to any one of preceding embodiments, and the low noise amplification device is coupled with the filter device.

Another embodiment of the present disclosure provides a radio frequency front-end device. The radio frequency front-end device includes a multiplexing device, and the multiplexing device includes at least one filter device according to any one of preceding embodiments.

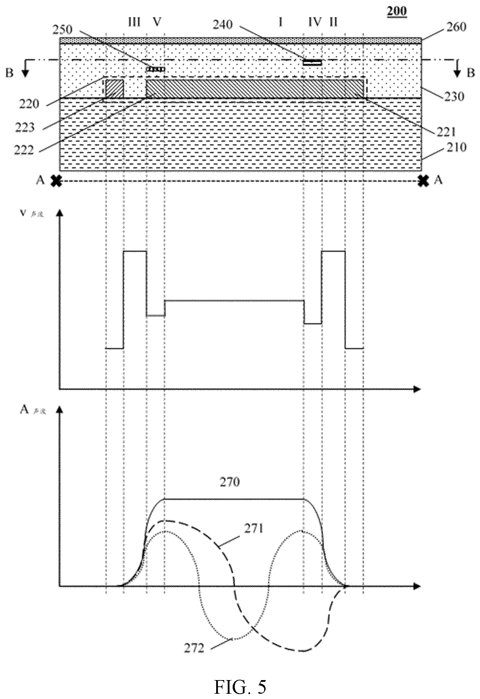

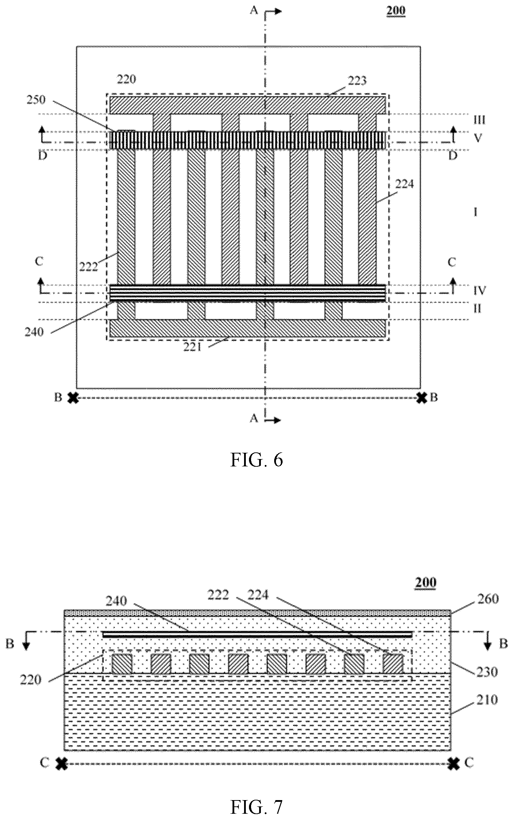

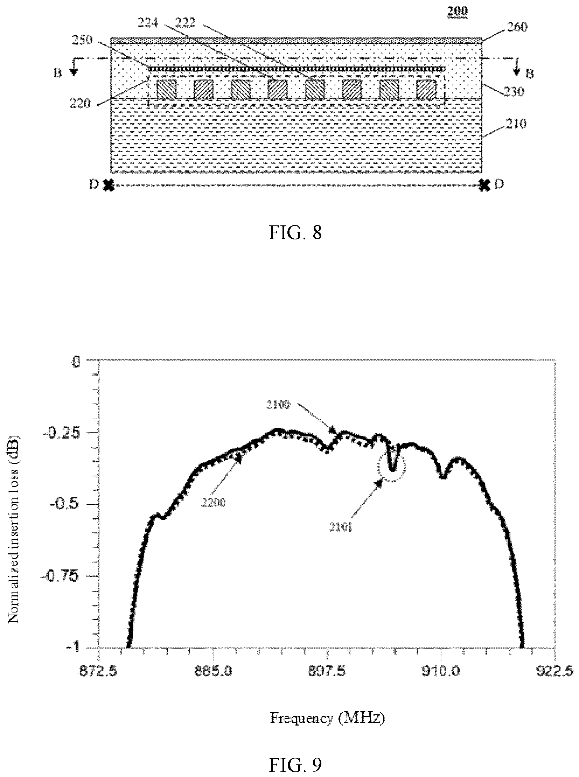

FIGS. 5 to 8 illustrate a specific embodiment of a SAW resonance device of the present disclosure, but the present disclosure may be implemented in other ways different from those described herein, and therefore is not limited by the specific embodiment disclosed below. FIG. 5 illustrates a schematic view of a first cross-section of a SAW resonance device 200 according to an embodiment of the present disclosure. FIG. 6 illustrates a schematic view of a top plane of the SAW resonance device 200 corresponding to the first cross-section according to an embodiment of the present disclosure. FIG. 7 illustrates a schematic view of a second cross-section of the SAW resonance device 200 according to an embodiment of the present disclosure. FIG. 8 illustrates a schematic view of a third cross-section of the SAW resonance device 200 according to an embodiment of the present disclosure.

FIG. 5 illustrates a schematic view of a first cross-section A of the SAW resonance device 200 and corresponding wave velocity and wave displacement according to an embodiment of the present disclosure.

As shown in FIG. 5, the SAW resonance device 200 includes a piezoelectric substrate 210, an electrode layer 220, a temperature compensation layer 230, a first load layer 240, a second load layer 250 and a frequency trimming layer 260. The electrode layer 220 is disposed on the piezoelectric substrate 210 along a vertical direction. The electrode layer 220 includes an IDT device. The IDT device includes a first busbar 221, multiple first electrode strips 222 and a second busbar 223. A first end of each of the first electrode strips 222 is coupled with the first busbar 221, and a second end of each of the first electrode strips 222 opposite to the first end is close to the second busbar 223 along a horizontal direction. A first gap is disposed between the second end and the second busbar 223. The temperature compensation layer 230 is disposed on the piezoelectric substrate 210 and covers the electrode layer 220. The first load layer 240 is disposed in the temperature compensation layer 230. The first load layer 240 is disposed close to the first end along the horizontal direction and above the first electrode strips 222 along the vertical direction. The first load layer 240 is in a strip shape and intersects with the first electrode strips 222 to form multiple first overlap portions. The first overlap portions are close to the first end along the horizontal direction, and the first end is disposed between the first overlap portions and the first busbar 221. The second load layer 250 is disposed in the temperature compensation layer 230. The second load layer 250 is disposed above the second end along the vertical direction and close to the first gap along the horizontal direction. The second load layer 250 is in a strip shape and intersects with the first electrode strips 222 to form multiple second overlap portions. The second overlap portions are close to the first gap along the horizontal direction, and the first gap is disposed between the second busbar 223 and the second overlap portions. A first height of the first load layer 240 relative to the first electrode strips 222 along the vertical direction is greater than a second height of the second load layer 250 relative to the first electrode strips 222 along the vertical direction, and a thickness of the first load layer 240 is greater than a thickness of the second load layer 250. The frequency trimming layer 260 is disposed on the temperature compensation layer 230.

In some embodiments, a material of the piezoelectric substrate 210 includes but is not limited to one of the following: lithium tantalate and lithium niobate.

In some embodiments, a material of the electrode layer 220 includes but is not limited to one of the following: molybdenum, ruthenium, tungsten, platinum, iridium, aluminum, beryllium, gold, titanium, copper, chromium, magnesium, scandium, and an alloy of any two or more of these materials. It should be noted that the IDT device may have a single-layer structure or a multi-layer structure, for example, the IDT device includes two IDT sublayers, one of which is made of aluminum, and the other one of which is made of tungsten.

In some embodiments, a material of the temperature compensation layer 230 includes but is not limited to one of the following: silicon dioxide and silicon oxyfluoride.

In some embodiments, a material of the first load layer 240 includes but is not limited to at least one of the following: molybdenum, ruthenium, tungsten, platinum, iridium, aluminum, beryllium, gold, titanium, copper, chromium, magnesium and scandium. It should be noted that the first load layer 240 may have a single-layer structure or a multi-layer structure. For example, the first load layer 240 includes two load sublayers, one of which is made of molybdenum, and the other one of which is made of titanium.

In some embodiments, a material of the second load layer 250 includes but is not limited to at least one of the following: molybdenum, ruthenium, tungsten, platinum, iridium, aluminum, beryllium, gold, titanium, copper, chromium, magnesium and scandium. It should be noted that the second load layer 250 may have a single-layer structure or a multi-layer structure.

In some embodiments, the material of the first load layer 240 may be the same as that of the second load layer 250. In some embodiments, the material of the first load layer may be different from that of the second load layer.

In some embodiments, the first height is greater than the second height, that is, the first load layer 240 is higher than the second load layer 250 along the vertical direction, and there is a first height difference between the first load layer 240 and the second load layer 250. It should be noted that by adjusting the height of the first load layer or the height of the second load layer, a height difference is formed between the first load layer and the second load layer so as to adjust a first resonance frequency of a corresponding region of the first load layer or a second resonance frequency of a corresponding region of the second load layer.

In some embodiments, a width of the first load layer 240 is equal to or approximate to a width of the second load layer 250. In some embodiments, the width of the first load layer is greater than or less than the width of the second load layer, and the thickness of the first load layer is equal to or approximate to the thickness of the second load layer. In some embodiments, the width of the first load layer is greater than or less than the width of the second load layer, and the thickness of the first load layer is greater than or less than the thickness of the second load layer. By adjusting size parameters of the first load layer (such as thickness, width) or size parameters of the second load layer (such as thickness, width), the resonance frequency of the corresponding region of the first load layer or the resonance frequency of the corresponding region of the second load layer can be adjusted.

In some embodiments, a material of the frequency trimming layer 260 includes but is not limited to one of the following: silicon nitride, aluminum nitride, silicon oxynitride, aluminum oxide and silicon carbide.

FIG. 6 illustrates a schematic view of a top plane B of the SAW resonance device 200 relative to the cross-section A according to an embodiment of the present disclosure.

Referring to FIG. 6, in some embodiments, the IDT device further includes multiple second electrode strips 224. A third end of each of the second electrode strips 224 is coupled with the second busbar 223, and a fourth end of each of the second electrode strips 224 opposite to the third end is close to the first busbar 221 along the horizontal direction. A second gap is disposed between the fourth end and the first busbar 221.

In some embodiments, the first electrode strips 222 are disposed between the first busbar 221 and the second busbar 223, and the second electrode strips 224 are disposed between the first busbar 221 and the second busbar 223. The first electrode strips 222 and the second electrode strips 224 are arranged alternately to each other. FIGS. 7 and 8 illustrate a schematic view of a cross-section C and a cross-section D of the SAW resonance device 200. As shown in FIGS. 7 and 8, two adjacent electrode strips are respectively coupled with the first busbar 221 and the second busbar 223.

In some embodiments, the first load layer 240 is disposed above the fourth end along the vertical direction and close to the second gap along the horizontal direction. The first load layer 240 intersects with the second electrode strips 224 to form multiple fourth overlap portions. The fourth overlap portions are close to the second gap along the horizontal direction, and the second gap is disposed between the first busbar 221 and the fourth overlap portions.

In some embodiments, the second load layer 250 is disposed close to the third end along the horizontal direction and above the second electrode strips 224 along the vertical direction. The second load layer 250 also intersects with the second electrode strips 224 to form multiple third overlap portions. The third overlap portions are disposed close to the third end along the horizontal direction, and the third end is disposed between the third overlap portions and the second busbar 223.

Referring to FIGS. 6 and 7, in some embodiments, the first load layer 240 is further disposed between adjacent first overlap portions and fourth overlap portions to connect the adjacent first overlap portions and fourth overlap portions.

Referring to FIGS. 6 and 8, in some embodiments, the second load layer 250 is further disposed between adjacent second overlap portions and third overlap portions to connect the adjacent second overlap portions and third overlap portions.

In some embodiments, a region between the first load layer 240 and the second load layer 250 constitutes a first region I. A region between the first busbar 221 and the first load layer 240 constitutes a second region II. A region between the second load layer 250 and the second busbar 223 constitutes a third region III. A region between the first region I and the second region II constitutes a fourth region IV A region between the first region I and the third region III constitutes a fifth region V A region where the first busbar 221 is located constitutes a first busbar region (unmarked), and a region where the second busbar 223 is located constitutes a second busbar region (unmarked). In some embodiments, the first load layer 240 is disposed in the fourth region IV, and the second load layer 250 is disposed in the fifth region V

In some embodiments, the fourth region IV is a portion of an overlap region of the first electrode strips 222 and the second electrode strips 224 that is close to the second gap, and the fifth region V is a portion of the overlap region of the first electrode strips 222 and the second electrode strips 224 that is close to the first gap.

Referring to the schematic view of the wave velocity in FIG. 5, the wave velocity in the first region I is lower than that in the second region II, the wave velocity in the first region I is lower than that in the third region III, the wave velocity in the first region I is greater than that in the fourth region IV, the wave velocity in the first region I is greater than that in the fifth region V, the wave velocity in the second region II is equal to or approximate to that in the third region III, and the wave velocity in the fourth region IV is lower than that in the fifth region V

Referring to the schematic view of the wave displacement in FIG. 5, a first wave displacement curve 270 represents a wave displacement distribution of Oth order acoustic wave in the piston mode, a second wave displacement curve 271 represents a wave displacement distribution of 1st order acoustic wave in the piston mode, and a third wave displacement curve 272 represents a wave displacement distribution of 2nd order acoustic wave in the piston mode. By reducing the wave velocity of the acoustic waves in the fourth region IV and the fifth region V to be lower than the wave velocity of the acoustic waves in the first region I, the piston mode is excited. In the piston mode, the wave displacement distribution in the first region I remains unchanged in the 0th mode. In the higher-order mode, the wave displacement distribution in the first region I follows integer multiples of a half cycle of a cosine curve, and an integration of the wave displacement distribution in the higher-order mode is 0. Therefore, higher-order acoustic waves in the first region I cannot be excited by electrodes, which suppresses transverse spurious resonance in the higher-order mode.

FIG. 9 illustrates a first passband portion 2100 of a first normalized insertion loss curve and a second passband portion 2200 of a second normalized insertion loss curve. The first passband portion 2100 corresponds to a first filter device. The first filter device includes a first SAW resonance device, and the first SAW resonance device includes a first load layer. The first load layer includes a first load portion and a second load portion respectively disposed at two lateral edge sides of a resonance region of the first SAW resonance device. A first height of the first load portion relative to the IDT of the first SAW resonance device is equal to or approximate to a second height of the second load portion relative to the IDT of the first SAW resonance device. As compared with FIG. 4, the first load layer can reduce transverse spurious resonance, while additional split spurious resonance (see a circled portion 2101) produced by the first load layer increases the insertion loss of the first filter device. The second passband portion 2200 corresponds to a second filter device. The second filter device includes a second SAW resonance device. The second SAW resonance device includes a second load layer (e.g., the first load layer 240) and a third load layer (e.g., the second load layer 250) respectively disposed at two lateral edge sides of a resonance region of a second SAW resonance device. A third height of the second load layer relative to the IDT of the second SAW resonance device is greater than a fourth height of the third load layer relative to the IDT of the second SAW resonance device. As compared with FIG. 4, the second load layer and the third load layer can reduce transverse spurious resonance. In addition, as compared with the first passband portion 2100, the second load layer and the third load layer can reduce split spurious resonance in the passband of the filter device produced by the load layer. It should be noted that a load layer will result in a split mode. In the split mode, split spurious resonance occurs in the passband of the filter device. A resonance frequency of the first load portion is equal to or approximate to that of the second load portion, so that the split spurious resonance of the first load portion superposes with the split spurious resonance of the second load portion to form a strong split spurious resonance in the passband of the filter device. Due to a relative height of the second load layer and that of the third load layer are different, a difference in the resonance frequency of the second load layer and the third load layer is relative great, thus the split spurious resonance of the second load layer can be partially cancelled out by the split spurious resonance of the third load layer, which can mitigate an overall split spurious resonance.

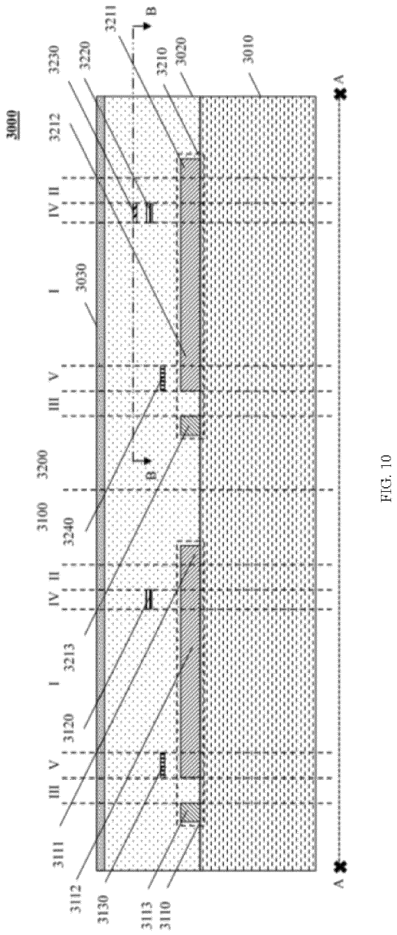

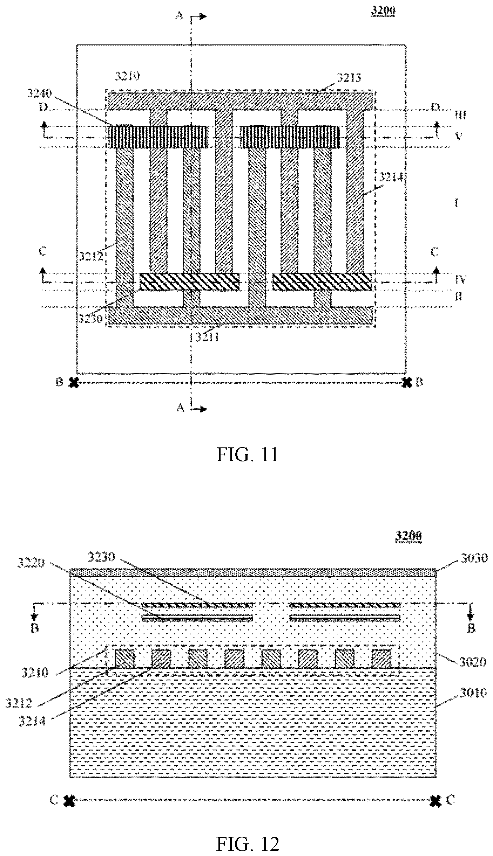

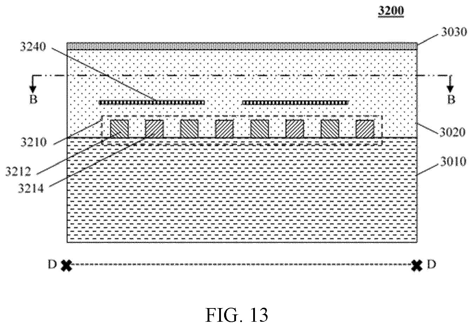

FIGS. 10 to 13 illustrate a specific embodiment of a SAW resonance device of the present disclosure, but the present disclosure may be implemented in other ways different from those described herein, and therefore is not limited by the specific embodiment disclosed below. FIG. 10 illustrates a schematic view of a first cross-section of an integrated SAW resonance device 3000 according to an embodiment of the present disclosure. FIG. 11 illustrates a schematic view of a top plane of a SAW resonance device 3200 corresponding to a first cross-section according to an embodiment of the present disclosure. FIG. 12 illustrates a schematic view of a second cross-section of the SAW resonance device 3200 according to an embodiment of the present disclosure. FIG. 13 illustrates a schematic view of a third cross-section of the SAW resonance device 3200 according to an embodiment of the present disclosure.

FIG. 10 illustrates a schematic view of a first cross-section A of an integrated SAW resonance device 3000 according to an embodiment of the present disclosure.

As shown in FIG. 10, the integrated SAW resonance device 3000 includes a first SAW resonance device 3100 and a second SAW resonance device 3200.

The first SAW resonance device 3100 includes a piezoelectric substrate 3010, a first electrode layer 3110, a temperature compensation layer 3020, a first load layer 3120, a second load layer 3130 and a frequency trimming layer 3030. The first electrode layer 3110 is disposed on the piezoelectric substrate 3010 along a vertical direction. The first electrode layer 3110 includes a first IDT device. The first IDT device includes a first busbar 3111, multiple first electrode strips 3112 and a second busbar 3113. A first end of each of the first electrode strips 3112 is coupled with the first busbar 3111, and a second end of each of the first electrode strips 3112 opposite to the first end along a horizontal direction is close to the second busbar 3113. A first gap is disposed between the second end and the second busbar 3113. The temperature compensation layer 3020 is disposed on the piezoelectric substrate 3010 and covers the first electrode layer 3110. The first load layer 3120 is disposed in the temperature compensation layer 3020. The first load layer 3120 is disposed close to the first end along the horizontal direction and above the first electrode strips 3112 along the vertical direction. The first load layer 3120 is in a strip shape and intersects with the first electrode strips 3112 to form multiple first overlap portions. The first overlap portions are close to the first end along the horizontal direction, and the first end is disposed between the first overlap portions and the first busbar 3111. The second load layer 3130 is disposed in the temperature compensation layer 3020. The second load layer 3130 is disposed above the second end along the vertical direction and close to the first gap along the horizontal direction. The second load layer 3130 is in a strip shape and intersects with the first electrode strips 3112 to form multiple second overlap portions. The second overlap portions are close to the first gap along the horizontal direction, and the first gap is disposed between the second busbar 3113 and the second overlap portions. A first height of the first load layer 3120 relative to the first electrode layer 3110 along the vertical direction is greater than a second height of the second load layer 3130 relative to the first electrode layer 3110 along the vertical direction, and a thickness of the first load layer 3120 is greater than a thickness of the second load layer 3130. The frequency trimming layer 3030 is disposed on the temperature compensation layer 3020.

The second SAW resonance device 3200 includes the piezoelectric substrate 3010, a second electrode layer 3210, the temperature compensation layer 3020, a third load layer 3220, a fourth load layer 3230, a fifth load layer 3240 and the frequency trimming layer 3030. The second electrode layer 3210 is disposed on the piezoelectric substrate 3010 along the vertical direction. The second electrode layer 3210 includes a second IDT device. The second IDT device includes a third busbar 3211, multiple third electrode strips 3212 and a fourth busbar 3213. A third end of each of the third electrode strips 3212 is coupled with the third busbar 3211, and a fourth end of each of the third electrode strips 3212 opposite to the third end along the horizontal direction is close to the fourth busbar 3213. A second gap is disposed between the fourth end and the fourth busbar 3213. The temperature compensation layer 3020 is disposed on the piezoelectric substrate 3010 and covers the second electrode layer 3210. The third load layer 3220 is disposed in the temperature compensation layer 3020. The third load layer 3220 is disposed close to the third end along the horizontal direction and above the third electrode strips 3212 along the vertical direction. The third load layer 3220 is in a strip shape and intersects with the third electrode strips 3212 to form multiple third overlap portions. The third overlap portions are close to the third end along the horizontal direction, and the third end is disposed between the third overlap portions and the third busbar 3211. The fourth load layer 3230 is disposed in the temperature compensation layer 3020. The fourth load layer 3230 is disposed close to the third end along the horizontal direction and above the third load layer 3220 along the vertical direction. The fourth load layer 3230 coincides with the third load layer 3220. The fourth load layer 3230 is in a strip shape and intersects with the third electrode strips 3212 to form multiple fourth overlap portions. The fourth overlap portions are close to the third end along the horizontal direction, and the third end is disposed between the fourth overlap portions and the third busbar 3211. A third height of the third load layer 3220 relative to the second electrode layer 3210 along the vertical direction is less than a fourth height of the fourth load layer 3230 relative to the second electrode layer 3210 along the vertical direction, and a thickness of the third load layer 3220 is greater than a thickness of the fourth load layer 3230. The fifth load layer 3240 is disposed in the temperature compensation layer 3020. The fifth load layer 3240 is disposed above the fourth end along the vertical direction and close to the second gap along the horizontal direction. The fifth load layer 3240 is in a strip shape and intersects with the third electrode strips 3212 to form multiple fifth overlap portions. The fifth overlap portions are close to the second gap along the horizontal direction, and the second gap is disposed between the fourth busbar 3213 and the fifth overlap portions. The third height is greater than a fifth height of the fifth load layer 3240 relative to the second electrode layer 3210 along the vertical direction, and the thickness of the fourth load layer 3230 is equal to or approximate to a thickness of the fifth load layer 3240. The frequency trimming layer 3030 is disposed on the temperature compensation layer 3020.

In some embodiments, a material of the piezoelectric substrate 3010 includes but is not limited to one of the following: lithium tantalate and lithium niobate.

In some embodiments, a material of the temperature compensation layer 3020 includes but is not limited to one of the following: silicon dioxide and silicon oxyfluoride.

In some embodiments, a material of the frequency trimming layer 3030 includes but is not limited to one of the following: silicon nitride, aluminum nitride, silicon oxynitride, aluminum oxide and silicon carbide.

In some embodiments, a material of the first electrode layer 3110 includes but is not limited to one of the following: molybdenum, ruthenium, tungsten, platinum, iridium, aluminum, beryllium, gold, titanium, copper, chromium, magnesium, scandium, and an alloy of any two or more of these materials. It should be noted that the first IDT device may have a single-layer structure or a multi-layer structure, for example, the first IDT device includes two IDT sublayers, one of which is made of aluminum, and the other one of which is made of tungsten.

In some embodiments, a material of the first load layer 3120 includes but is not limited to one of the following: molybdenum, ruthenium, tungsten, platinum, iridium, aluminum, beryllium, gold, titanium, copper, chromium, magnesium and scandium. It should be noted that the first load layer 3120 may have a single-layer structure or a multi-layer structure. For example, the first load layer 3120 includes two load sublayers, one of which is made of molybdenum, and the other one of which is made of titanium.

In some embodiments, a material of the second load layer 3130 includes but is not limited to one of the following: molybdenum, ruthenium, tungsten, platinum, iridium, aluminum, beryllium, gold, titanium, copper, chromium, magnesium and scandium. It should be noted that the second load layer 3130 may have a single-layer structure or a multi-layer structure.

In some embodiments, a width of the first load layer 3120 is less than a width of the second load layer 3130.

In some embodiments, the material of the first load layer 3120 may be the same as that of the second load layer 3130. In some embodiments, the material of the first load layer may be different from that of the second load layer.

In some embodiments, a material of the second electrode layer 3210 includes but is not limited to one of the following: molybdenum, ruthenium, tungsten, platinum, iridium, aluminum, beryllium, gold, titanium, copper, chromium, magnesium, scandium, and an alloy of any two or more of these materials. It should be noted that the second IDT device may have a single-layer structure or a multi-layer structure, for example, the second IDT device includes two IDT sublayers, one of which is made of aluminum, and the other one of which is made of tungsten.

In some embodiments, a material of the third load layer 3220 includes but is not limited to one of the following: molybdenum, ruthenium, tungsten, platinum, iridium, aluminum, beryllium, gold, titanium, copper, chromium, magnesium and scandium. It should be noted that the third load layer 3220 may have a single-layer structure or a multi-layer structure. For example, the third load layer 3220 includes two load sublayers, one of which is made of molybdenum, and the other one of which is made of titanium.

In some embodiments, a material of the fourth load layer 3230 includes but is not limited to one of the following: molybdenum, ruthenium, tungsten, platinum, iridium, aluminum, beryllium, gold, titanium, copper, chromium, magnesium and scandium. It should be noted that the fourth load layer 3230 may have a single-layer structure or a multi-layer structure.

In some embodiments, a material of the fifth load layer 3240 includes but is not limited to one of the following: molybdenum, ruthenium, tungsten, platinum, iridium, aluminum, beryllium, gold, titanium, copper, chromium, magnesium and scandium. It should be noted that the fifth load layer 3240 may have a single-layer structure or a multi-layer structure.

In some embodiments, a width of the third load layer 3220 may be equal to or approximate to a width of the fourth load layer 3230, and the width of the third load layer 3220 may be less than a width of the fifth load layer 3240.

In some embodiments, the width and thickness of the third load layer 3220 may be equal to or approximate to the width and thickness of the first load layer 3120, and the width and thickness of the fifth load layer 3240 may be equal to or approximate to the width and thickness of the second load layer 3130.

In some embodiments, the fourth load layer is disposed above the fifth load layer along the vertical direction and coincides with the fifth load layer to further mitigate the split mode of the SAW resonance device.

In some embodiments, the material of the third load layer 3220 may be the same as the material of the fourth load layer 3230. In some embodiments, the material of the third load layer may be different from the material of the fourth load layer.

In some embodiments, the material of the third load layer 3220 may be the same as the material of the fifth load layer 3240. In some embodiments, the material of the third load layer may be different from the material of the fifth load layer.

FIG. 11 illustrates a schematic view of a top plane B of the second SAW resonance device 3200 relative to the cross-section A according to an embodiment of the present disclosure.

Referring to FIG. 11, in some embodiments, the second IDT device further includes multiple fourth electrode strips 3214. A fifth end of each of the fourth electrode strips 3214 is coupled with the fourth busbar 3213, and a sixth end of each of the fourth electrode strips 3214 opposite to the fifth end along the horizontal direction is close to the third busbar 3211. A third gap is disposed between the sixth end and the third busbar 3211.

In some embodiments, the third electrode strips 3212 are disposed between the third busbar 3211 and the fourth busbar 3213, and the fourth electrode strips 3214 are disposed between the third busbar 3211 and the fourth busbar 3213. The third electrode strips 3212 and the fourth electrode strips 3214 are arranged alternately to each other. FIGS. 12 and 13 illustrate a schematic view of a cross-section C and a cross-section D of the second SAW resonance device 3200. Two adjacent electrode strips are respectively coupled with the third busbar 3211 and the fourth busbar 3213.

In some embodiments, the third load layer 3220 is disposed above the sixth end along the vertical direction and close to the third gap along the horizontal direction. The third load layer 3220 is in a strip shape and intersects with the fourth electrode strips 3214 to form multiple sixth overlap portions. The sixth overlap portions are close to the third gap, and the third gap is disposed between the sixth overlap portions and the third busbar 3211.

In some embodiments, the fourth load layer 3230 is disposed above the third load layer 3220 along the vertical direction and close to the third gap along the horizontal direction. The fourth load layer 3230 coincides with the third load layer 3220. The fourth load layer 3230 is in a strip shape and intersects with the fourth electrode strips 3214 to form multiple seventh overlap portions. The seventh overlap portions are close to the third gap, and the third gap is disposed between the seventh overlap portions and the third busbar 3211.

In some embodiments, the fifth load layer 3240 is disposed close to the fifth end along the horizontal direction and above the fourth electrode strips 3214 along the vertical direction. The fifth load layer 3240 is in a strip shape and intersects with the fourth electrode strips 3214 to form multiple eighth overlap portions. The eighth overlap portions are close to the fifth end, and the fifth end is disposed between the eighth overlap portions and the fourth busbar 3213.

In some embodiments, as shown in FIGS. 11 and 12, the third load layer 3220 includes multiple third load portions, and each of the third load portions includes two sixth overlap portions and a third overlap portion disposed between the two sixth overlap portions. The third electrode strips adjacent to the third overlap portion are disposed between adjacent two third load portions. In some embodiments, the third load portions are in a strip shape.

In some embodiments, as shown in FIGS. 11 and 12, the fourth load layer 3230 includes multiple fourth load portions, and each of the fourth load portions includes two seventh overlap portions and a fourth overlap portion disposed between the two seventh overlap portions. The third electrode strips adjacent to the fourth overlap portion are disposed between adjacent two fourth load portions. In some embodiments, the fourth load portions are in a strip shape.

In some embodiments, as shown in FIGS. 11 and 13, the fifth load layer 3240 includes multiple fifth load portions, and each of the fifth load portions includes two fifth overlap portions and an eighth overlap portion disposed between the two fifth overlap portions. The fourth electrode strips adjacent to the eighth overlap portion are disposed between adjacent two fifth load portions. In some embodiments, the fifth load portions are in a strip shape.

In some embodiments, a region between the fourth load layer 3230 and the fifth load layer 3240 constitutes a first region I, a region between the third busbar 3211 and the fourth load layer 3230 constitutes a second region II, a region between the fifth load layer 3240 and the fourth busbar 3213 constitutes a third region III, a region between the first region I and the second region II constitutes a fourth region IV, and a region between the first region I and the third region III constitutes a fifth region V A region where the third busbar 3211 is located constitutes a first busbar region (unmarked), and a region where the fourth busbar 3213 is located constitutes a second busbar region (unmarked). In some embodiments, the third load layer 3220 is disposed in the fourth region IV, the fourth load layer 3230 is disposed in the fourth region IV, and the fifth load layer 3240 is disposed in the fifth region V

In some embodiments, the fourth region IV is a portion of an overlap region of the third electrode strips 3212 and the fourth electrode strips 3214 that is close to the third gap, and the fifth region V is a portion of the overlap region of the third electrode strips 3212 and the fourth electrode strips 3214 that is close to the second gap.

By integrating the first SAW resonance device and the second SAW resonance device, the first load layer and the second load layer are respectively disposed at two lateral edge areas of the resonance region of the first SAW resonance device, and the third load layer and the fourth load layer are respectively disposed at two lateral edge areas of the resonance region of the second SAW resonance device. The parameters of the first load layer (such as relative height, width and thickness) are equal to or approximate to those of the third load layer, and the parameters of the second load layer are equal to or approximate to those of the fourth load layer, thus the integrated SAW resonance device is in the piston mode, which can suppress transverse spurious resonance in the higher-order mode. However, due to the difference in resonance frequency between the first SAW resonance device and the second SAW resonance device, the arrangement of above load layers cannot simultaneously meet the requirements of the integrated SAW resonance device for mitigating the split mode. For example, the first SAW resonance device meets the requirements, while the second SAW resonance device does not meet the requirements. In some embodiment of the present disclosure, a third load layer, i.e., the fifth load layer, is introduced into the second SAW resonance device, to further adjust the split mode of the second SAW resonance device by setting the parameters of the fifth load layer (such as relative height, thickness and width), and to meet the requirements of mitigating the split mode of the second SAW resonance device.

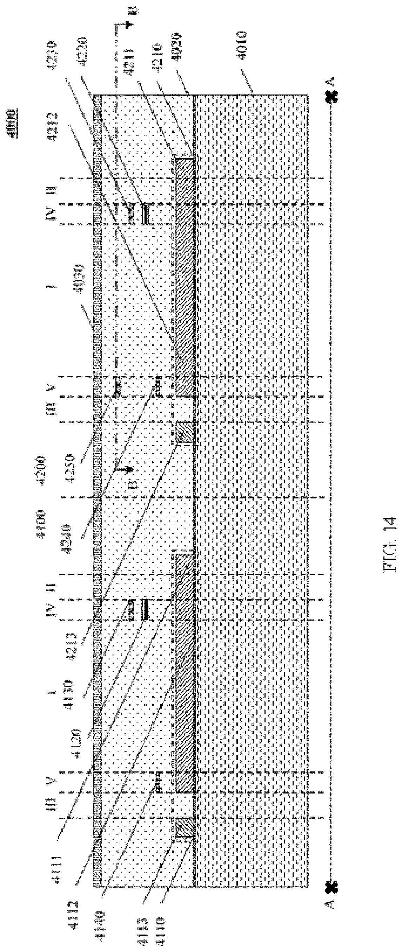

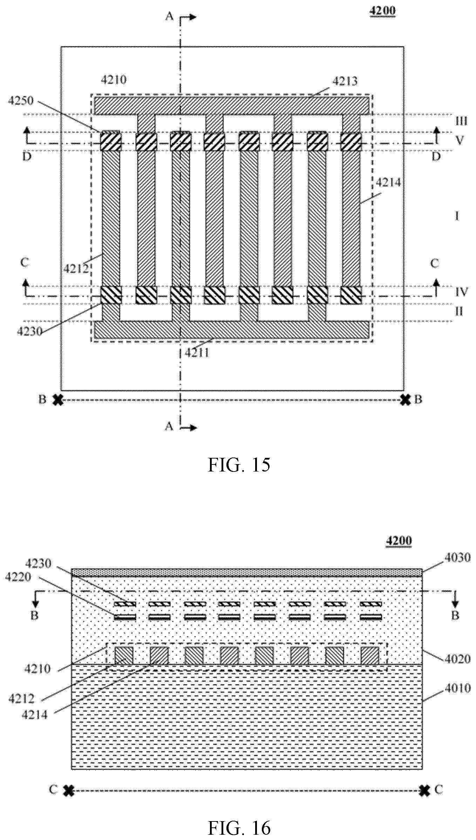

FIGS. 14 to 17 illustrate a specific embodiment of a SAW resonance device of the present disclosure, but the present disclosure may be implemented in other ways different from those described herein, and therefore is not limited by the specific embodiment disclosed below. FIG. 14 illustrates a schematic view of a first cross-section of an integrated SAW resonance device 4000 according to an embodiment of the present disclosure. FIG. 15 illustrates a schematic view of a top plane of a SAW resonance device 4200 corresponding to the first cross-section according to an embodiment of the present disclosure. FIG. 16 illustrates a schematic view of a second cross-section of the SAW resonance device 4200 according to an embodiment of the present disclosure. FIG. 14 illustrates a schematic view of a third cross-section of the SAW resonance device 4200 according to an embodiment of the present disclosure.

FIG. 14 illustrates a schematic view of a first cross-section A of the SAW resonance device 4000 according to an embodiment of the present disclosure.

As shown in FIG. 14, the integrated SAW resonance device 4000 includes a first SAW resonance device 4100 and a second SAW resonance device 4200.

The first SAW resonance device 4100 includes a piezoelectric substrate 4010, a first electrode layer 4110, a temperature compensation layer 4020, a first load layer 4120, a second load layer 4130, a third load layer 4140 and a frequency trimming layer 4030. The first electrode layer 4110 is disposed on the piezoelectric substrate 3010 along a vertical direction. The first electrode layer 4110 includes a first IDT device. The first IDT device includes a first busbar 4111, multiple first electrode strips 4112 and a second busbar 4113. A first end of each of the first electrode strips 4112 is coupled with the first busbar 4111, and a second end of each of the first electrode strips 4112 opposite to the first end along a horizontal direction is close to the second busbar 4113. A first gap is disposed between the second end and the second busbar 4113. The temperature compensation layer 4020 is disposed on the piezoelectric substrate 4010 and covers the first electrode layer 4110. The first load layer 4120 is disposed in the temperature compensation layer 4020. The first load layer 4120 is disposed close to the first end along the horizontal direction and above the first electrode strips 4112 along the vertical direction. The first load layer 4120 is in a strip shape and intersects with the first electrode strips 4112 to form multiple first overlap portions. The first overlap portions are close to the first end along the horizontal direction, and the first end is disposed between the first overlap portions and the first busbar 4111. The second load layer 4130 is disposed in the temperature compensation layer 4020. The second load layer 4130 is disposed close to the first end along the horizontal direction and above the first load layer 4120 along the vertical direction. The second load layer 4130 coincides with the first load layer 4120. The second load layer 4130 is in a strip shape and intersects with the first electrode strips 4112 to form multiple second overlap portions. The second overlap portions are close to the first end along the horizontal direction, and the first end is disposed between the second overlap portions and the first busbar 4111. A first height of the first load layer 4120 relative to the first electrode layer 4110 along the vertical direction is greater than a second height of the second load layer 4130 relative to the first electrode layer 4110 along the vertical direction, and a thickness of the first load layer 4120 is greater than a thickness of the second load layer 4130. The third load layer 4140 is disposed in the temperature compensation layer 4020. The third load layer 4140 is disposed above the second end along the vertical direction and close to the first gap along the horizontal direction. The third load layer 4140 is in a strip shape and intersects with the first electrode strips 4112 to form multiple third overlap portions. The third overlap portions are close to the first gap along the horizontal direction, and the first gap is disposed between the second busbar 4113 and the third overlap portions. The first height is greater than a third height of the third load layer 4140 relative to the first electrode layer 4110 along the vertical direction, the thickness of the first load layer 4120 is greater than a thickness of the third load layer 4140, and the thickness of the second load layer 4130 is equal to or approximate to the thickness of the third load layer 414. The frequency trimming layer 4030 is disposed on the temperature compensation layer 4020.

The second SAW resonance device 4200 includes the piezoelectric substrate 4010, a second electrode layer 4210, the temperature compensation layer 4020, a fourth load layer 4220, a fifth load layer 4230, a sixth load layer 4240, a seventh load layer 4250 and the frequency trimming layer 4030. The second electrode layer 4210 is disposed on the piezoelectric substrate 4010 along the vertical direction. The second electrode layer 4210 includes a second IDT device. The second IDT device includes a third busbar 4211, multiple third electrode strips 4212 and a fourth busbar 4213. A third end of each of the third electrode strips 4212 is coupled with the third busbar 4211, and a fourth end of each of the third electrode strips 4212 opposite to the third end along the horizontal direction is close to the fourth busbar 4213. A second gap is disposed between the fourth end and the fourth busbar 4213. The temperature compensation layer 4020 is disposed on the piezoelectric substrate 4010 and covers the second electrode layer 4210. The fourth load layer 4220 is disposed in the temperature compensation layer 4020. The fourth load layer 4220 is disposed close to the third end along the horizontal direction and above the third electrode strips 4212 along the vertical direction. The fourth load layer 4220 is in a strip shape and intersects with the third electrode strips 4212 to form multiple fourth overlap portions. The fourth overlap portions are close to the third end along the horizontal direction, and the third end is disposed between the fourth overlap portions and the third busbar 4211. The fifth load layer 4230 is disposed in the temperature compensation layer 4020. The fifth load layer 4230 is disposed close to the third end along the horizontal direction and above the fourth load layer 4220 along the vertical direction. The fifth load layer 4230 coincides with the fourth load layer 4220. The fifth load layer 4230 is in a strip shape and intersects with the third electrode strips 4212 to form multiple fifth overlap portions. The fifth overlap portions are close to the third end along the horizontal direction, and the third end is disposed between the fifth overlap portions and the third busbar 4211. A fourth height of the fourth load layer 4220 relative to the second electrode layer 4210 along the vertical direction is less than a fifth height of the fifth load layer 4230 relative to the second electrode layer 4210 along the vertical direction, and a thickness of the fourth load layer 4220 is greater than a thickness of the fifth load layer 4230. The sixth load layer 4240 is disposed in the temperature compensation layer 4020. The sixth load layer 4240 is disposed above the fourth end along the vertical direction and close to the second gap along the horizontal direction. The sixth load layer 4240 is in a strip shape and intersects with the third electrode strips 4212 to form multiple sixth overlap portions. The sixth overlap portions are close to the second gap along the horizontal direction, and the second gap is disposed between the fourth busbar 4213 and the sixth overlap portions. The fourth height is greater than a sixth height of the sixth load layer 4240 relative to the second electrode layer 4210 along the vertical direction, the thickness of the fourth load layer 4220 is greater than a thickness of the sixth load layer 4240, and the thickness of the fifth load layer 4230 is equal to or approximate to the thickness of the sixth load layer 4240. The seventh load layer 4250 is disposed in the temperature compensation layer 4020. The seventh load layer 4250 is disposed above the sixth load layer 4240 along the vertical direction and close to the second gap along the horizontal direction. The seventh load layer 4250 coincides with the sixth load layer 4240. The seventh load layer 4250 is in a strip shape and intersects with the third electrode strips 4212 to form multiple seventh overlap portions. The seventh overlap portions are close to the second gap along the horizontal direction, and the second gap is disposed between the fourth busbar 4213 and the seventh overlap portions. The fifth height is less than a seventh height of the seventh load layer 4250 relative to the second electrode layer 4210 along the vertical direction, a thickness of the seventh load layer 4250 is greater than the thickness of the sixth load layer 4240, and the thickness of the seventh load layer 4250 is less than the thickness of the fourth load layer 4220. The frequency trimming layer 4030 is disposed on the temperature compensation layer 4020.

In some embodiments, a material of the piezoelectric substrate 4010 includes but is not limited to one of the following: lithium tantalate and lithium niobate.

In some embodiments, a material of the temperature compensation layer 4020 includes but is not limited to one of the following: silicon dioxide and silicon oxyfluoride.

In some embodiments, a material of the frequency trimming layer 4030 includes but is not limited to one of the following: silicon nitride, aluminum nitride, silicon oxynitride, aluminum oxide and silicon carbide.

In some embodiments, a material of the first electrode layer 4110 includes but is not limited to one of the following: molybdenum, ruthenium, tungsten, platinum, iridium, aluminum, beryllium, gold, titanium, copper, chromium, magnesium, scandium, and an alloy of any two or more of these materials. It should be noted that the first IDT device may have a single-layer structure or a multi-layer structure, for example, the first IDT device includes two IDT sublayers, one of which is made of aluminum, and the other one of which is made of tungsten.

In some embodiments, a material of the first load layer 4120 includes but is not limited to one of the following: molybdenum, ruthenium, tungsten, platinum, iridium, aluminum, beryllium, gold, titanium, copper, chromium, magnesium and scandium. It should be noted that the first load layer 4120 may have a single-layer structure or a multi-layer structure. For example, the first load layer 4120 includes two load sublayers, one of which is made of molybdenum, and the other one of which is made of titanium.

In some embodiments, a material of the second load layer 4130 includes but is not limited to one of the following: molybdenum, ruthenium, tungsten, platinum, iridium, aluminum, beryllium, gold, titanium, copper, chromium, magnesium and scandium. It should be noted that the second load layer 4130 may have a single-layer structure or a multi-layer structure.

In some embodiments, a material of the third load layer 4140 includes but is not limited to one of the following: molybdenum, ruthenium, tungsten, platinum, iridium, aluminum, beryllium, gold, titanium, copper, chromium, magnesium and scandium. It should be noted that the third load layer 4140 may have a single-layer structure or a multi-layer structure.

In some embodiments, a width of the first load layer 4120 is equal to or approximate to a width of the second load layer 4130, and the width of the first load layer 4120 is equal to or approximate to a width of the third load layer 4140.

In some embodiments, the material of the first load layer 4120 may be the same as that of the second load layer 4130. In some embodiments, the material of the first load layer may be different from that of the second load layer.

In some embodiments, the material of the first load layer 4120 may be the same as that of the third load layer 4130. In some embodiments, the material of the first load layer may be different from that of the third load layer.

In some embodiments, a material of the second electrode layer 4210 includes but is not limited to one of the following: molybdenum, ruthenium, tungsten, platinum, iridium, aluminum, beryllium, gold, titanium, copper, chromium, magnesium, scandium, and an alloy of any two or more of these materials. It should be noted that the second IDT device may have a single-layer structure or a multi-layer structure, for example, the second IDT device includes two IDT sublayers, one of which is made of aluminum, and the other one of which is made of tungsten.

In some embodiments, a material of the fourth load layer 4220 includes but is not limited to at least one of the following: molybdenum, ruthenium, tungsten, platinum, iridium, aluminum, beryllium, gold, titanium, copper, chromium, magnesium and scandium. It should be noted that the fourth load layer 4220 may have a single-layer structure or a multi-layer structure. For example, the fourth load layer 4220 includes two load sublayers, one of which is made of molybdenum, and the other one of which is made of titanium.

In some embodiments, a material of the fifth load layer 4230 includes but is not limited to one of the following: molybdenum, ruthenium, tungsten, platinum, iridium, aluminum, beryllium, gold, titanium, copper, chromium, magnesium and scandium. It should be noted that the fifth load layer 4230 may have a single-layer structure or a multi-layer structure.

In some embodiments, a material of the sixth load layer 4240 includes but is not limited to one of the following: molybdenum, ruthenium, tungsten, platinum, iridium, aluminum, beryllium, gold, titanium, copper, chromium, magnesium and scandium. It should be noted that the sixth load layer 4240 may have a single-layer structure or a multi-layer structure.

In some embodiments, a material of the seventh load layer 4250 includes but is not limited to one of the following: molybdenum, ruthenium, tungsten, platinum, iridium, aluminum, beryllium, gold, titanium, copper, chromium, magnesium and scandium. It should be noted that the seventh load layer 4250 may have a single-layer structure or a multi-layer structure.

In some embodiments, a width of the fourth load layer 4220 is equal to or approximate to a width of the fifth load layer 4230. In some embodiments, a width of the sixth load layer 4240 is equal to or approximate to a width of the seventh load layer 4250, and the width of the fifth load layer 4230 is equal to or approximate to the width of the seventh load layer 4250.

In some embodiments, the width and thickness of the fourth load layer 4220 are equal to or approximate to those of the first load layer 4120, the width and thickness of the fifth load layer 4230 are equal to or approximate to those of the second load layer 4130, and the width and thickness of the sixth load layer 4240 are equal to or approximate to those of the third load layer 4140.

In some embodiments, the sixth load layer is disposed above the seventh load layer along the vertical direction and coincides with the seventh load layer to further mitigate the split mode of the SAW resonance device.

In some embodiments, the material of the fourth load layer 4220 may be the same as that of the fifth load layer 4230. In some embodiments, the material of the fourth load layer may be different from that of the fifth load layer.

In some embodiments, the material of the sixth load layer 4240 may be the same as that of the seventh load layer 4250. In some embodiments, the material of the sixth load layer may be different from that of the seventh load layer.

In some embodiments, the material of the fourth load layer 4220 may be the same as that of the sixth load layer 4240. In some embodiments, the material of the fourth load layer may be different from that of the sixth load layer.

FIG. 15 illustrates a schematic view of a top plane B of the second SAW resonance device 4200 relative to the cross-section A according to an embodiment of the present disclosure.

Referring to FIG. 15, in some embodiments, the second IDT device further includes multiple fourth electrode strips 4214. A fifth end of each of the fourth electrode strips 4214 is coupled with the fourth busbar 4213, and a sixth end of each of the fourth electrode strips 4214 opposite to the fifth end along the horizontal direction is close to the third busbar 4211. A third gap is disposed between the sixth end and the third busbar 4211.

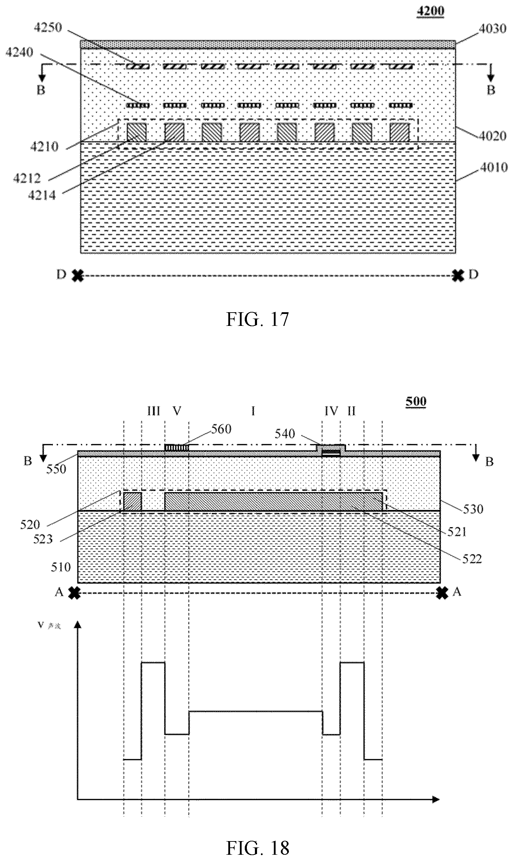

In some embodiments, the third electrode strips 4212 are disposed between the third busbar 4211 and the fourth busbar 4213, and the fourth electrode strips 4214 are disposed between the third busbar 4211 and the fourth busbar 4213. The third electrode strips 4212 and the fourth electrode strips 4214 are arranged alternately to each other. FIGS. 16 and 17 illustrate a schematic view of a cross-section C and a cross-section D of the second SAW resonance device 4200. Two adjacent electrode strips are respectively coupled with the third busbar 4211 and the fourth busbar 4213.

In some embodiments, the fourth load layer 4220 is disposed above the sixth end along the vertical direction and close to the third gap along the horizontal direction. The fourth load layer 4220 is in a strip shape and intersects with the fourth electrode strips 4214 to form multiple eighth overlap portions. The eighth overlap portions are close to the third gap, and the third gap is disposed between the eight overlap portions and the third busbar 4211.

In some embodiments, the fifth load layer 4230 is disposed above the sixth end along the vertical direction and close to the third gap along the horizontal direction. The fifth load layer 4230 is in a strip shape and intersects with the fourth electrode strips 4214 to form multiple ninth overlap portions. The ninth overlap portions are close to the third gap, and the third gap is disposed between the ninth overlap portions and the third busbar 4211.

In some embodiments, the sixth load layer 4240 is disposed close to the fifth end along the horizontal direction and above the fourth electrode strips 4214 along the vertical direction. The sixth load layer 4240 is in a strip shape and intersects with the fourth electrode strips 4214 to form multiple tenth overlap portions. The tenth overlap portions are close to the fifth end, and the fifth end is disposed between the tenth overlap portions and the fourth busbar 4213.

In some embodiments, the seventh load layer 4250 is disposed close to the fifth end along the horizontal direction and above the sixth load layer 4240 along the vertical direction. The seventh load layer 4250 is in a strip shape and intersects with the fourth electrode strips 4214 to form multiple eleventh overlap portions. The eleventh overlap portions are close to the fifth end, and the fifth end is disposed between the eleventh overlap portions and the fourth busbar 4213.

In some embodiments, as shown in FIGS. 15 and 16, the fourth load layer 4220 includes multiple fourth overlap portions and multiple eighth overlap portions. The fourth overlap portions are disposed above the third electrode strips 4212 corresponding to the third electrode strips 4212 respectively. The eighth overlap portions are disposed above the fourth electrode strips 4214 corresponding to the fourth electrode strips 4214 respectively. A gap between adjacent fourth overlap portion and eighth overlap portion corresponds to a gap between adjacent third electrode strip and fourth electrode strip.

In some embodiments, as shown in FIGS. 15 and 16, the fifth load layer 4230 includes multiple fifth overlap portions and multiple ninth overlap portions. The fifth overlap portions are disposed above the fourth overlap portions corresponding to the fourth overlap portions respectively. The ninth overlap portions are disposed above the eighth overlap portions corresponding to the eighth overlap portions respectively. A gap between adjacent fifth overlap portion and ninth overlap portion corresponds to a gap between adjacent fourth overlap portion and eighth overlap portion.

In some embodiments, as shown in FIGS. 15 and 17, the sixth load layer 4240 includes multiple sixth overlap portions and multiple tenth overlap portions. The sixth overlap portions are disposed above the third electrode strips 4212 corresponding to the third electrode strips 4212 respectively. The tenth overlap portions are disposed above the fourth electrode strips 4214 corresponding to the fourth electrode strips 4214 respectively. A gap between adjacent sixth overlap portion and tenth overlap portion corresponds to a gap between adjacent third electrode strip and fourth electrode strip.

In some embodiments, as shown in FIGS. 15 and 17, the seventh load layer 4250 includes multiple seventh overlap portions and multiple eleventh overlap portions. The seventh overlap portions are disposed above the sixth overlap portions corresponding to the sixth overlap portions respectively. The eleventh overlap portions are disposed above the tenth overlap portions corresponding to the tenth overlap portions respectively. A gap between adjacent seventh overlap portion and eleventh overlap portion corresponds to a gap between adjacent sixth overlap portion and tenth overlap portion.

In some embodiments, a region between the fifth load layer 4230 and the seventh load layer 4250 constitutes a first region I, a region between the third busbar 4211 and the fifth load layer 4230 constitutes a second region II, a region between the seventh load layer 4250 and the fourth busbar 4213 constitutes a third region III, a region between the first region I and the second region II constitutes a fourth region IV, and a region between the first region I and the third region III constitutes a fifth region V A region where the third busbar 4211 is located constitutes a first busbar region (unmarked), and a region where the fourth busbar 4213 is located constitutes a second busbar region (unmarked). In some embodiments, the fourth load layer 4220 is disposed in the fourth region IV, the fifth load layer 4230 is disposed in the fourth region IV, the sixth load layer 4240 is disposed in the fifth region V, and the seventh load layer 4250 is disposed in the fifth region V

In some embodiments, the fourth region IV is a portion of an overlap region of the third electrode strips 4212 and the fourth electrode strips 4214 that is close to the third gap, and the fifth region V is a portion of the overlap region of the third electrode strips 4212 and the fourth electrode strips 4214 that is close to the second gap.

By integrating the first SAW resonance device and the second SAW resonance device, the first load layer and the second load layer are disposed at a first lateral edge side of a resonance region of the first SAW resonance device and the third load layer is disposed at a second lateral edge side of the resonance region of the first SAW resonance device, and the fourth load layer and the fifth load layer are disposed at a third lateral edge side of a resonance region of the second SAW resonance device and the sixth load layer is disposed at a fourth lateral edge side of the resonance region of the second SAW resonance device. The parameters of the first load layer (such as relative height, width and thickness) are equal to or approximate to those of the fourth load layer, the parameters of the second load layer are equal to or approximate to those of the fifth load layer, and the parameters of the third load layer are equal to or approximate to those of the sixth load layer, thus the integrated SAW resonance device is in the piston mode, which can suppress transverse spurious resonance in the higher-order mode. However, due to the difference in resonance frequency between the first SAW resonance device and the second SAW resonance device, the arrangement of above load layers cannot simultaneously meet the requirements of the integrated SAW resonance device for mitigating the split mode. For example, the first SAW resonance device meets the requirements, while the second SAW resonance device does not meet the requirements. In some embodiment of the present disclosure, a fourth load layer, i.e., the seventh load layer, is introduced into the second SAW resonance device, to further adjust the split mode of the second SAW resonance device by setting the parameters of the seventh load layer (such as relative height, thickness and width), and to meet the requirements of mitigating the split mode of the second SAW resonance device.

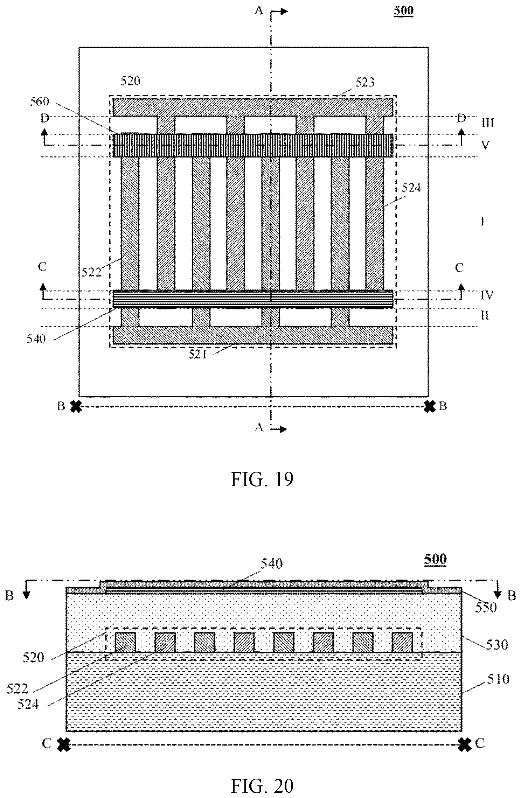

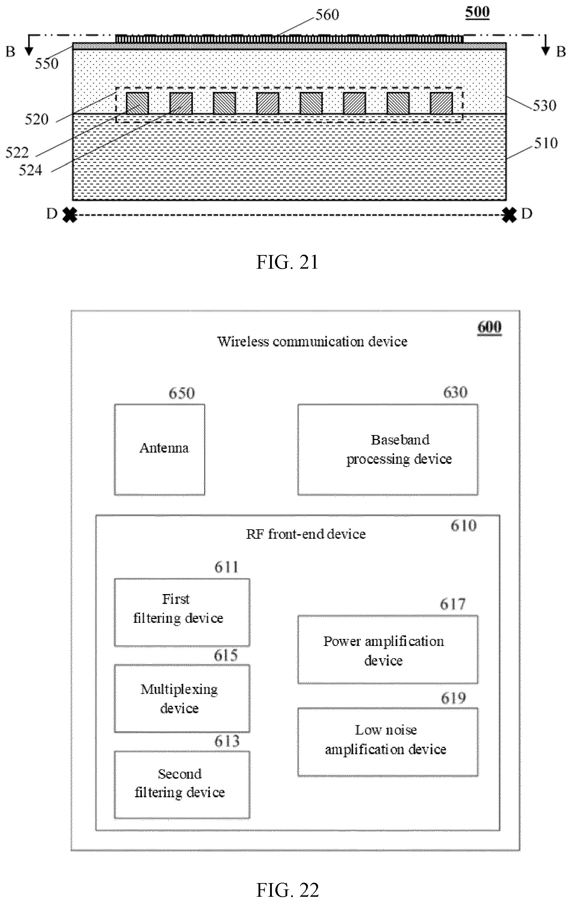

FIGS. 18 to 21 illustrate a specific embodiment of a SAW resonance device of the present disclosure, but the present disclosure may be implemented in other ways different from those described herein, and therefore is not limited by the specific embodiment disclosed below. FIG. 18 illustrates a schematic structure view of a first cross-section of a SAW resonance device 500 according to an embodiment of the present disclosure. FIG. 19 illustrates a schematic view of a top plane of the SAW resonance device 500 corresponding to the first cross-section according to an embodiment of the present disclosure. FIG. 20 illustrates a schematic view of a second cross-section of the SAW resonance device 500 according to an embodiment of the present disclosure. FIG. 21 illustrates a schematic view of a third cross-section of the SAW resonance device 500 according to an embodiment of the present disclosure.

FIG. 18 illustrates a schematic view of a first cross-section A of the SAW resonance device 500 and corresponding wave velocity according to an embodiment of the present disclosure.

As shown in FIG. 18, the SAW resonance device 500 includes a piezoelectric substrate 510, an electrode layer 520, a temperature compensation layer 530, a first load layer 540, a frequency trimming layer 550 and a second load layer 560. The electrode layer 520 is disposed on the piezoelectric substrate 510 along a vertical direction. The electrode layer 520 includes an IDT device. The IDT device includes a first busbar 521, multiple first electrode strips 522 and a second busbar 523. A first end of each of the first electrode strips 522 is coupled with the first busbar 521, a second end of each of the first electrode strips 522 opposite to the first end along a horizontal direction is close to the second busbar 523, and a first gap is disposed between the second end and the second busbar 523. The temperature compensation layer 530 is disposed on the piezoelectric substrate 510 and covers the electrode layer 520. The first load layer 540 is disposed on the temperature compensation layer 530. The first load layer 540 is close to the first end along the horizontal direction and above the first electrode strips 522 along the vertical direction. The first load layer 540 is in a strip shape and intersects with the first electrode strips 522 to form multiple first overlap portions. The first overlap portions are close to the first end along the horizontal direction, and the first end is disposed between the first overlap portions and the first busbar 521. The frequency trimming layer 550 is disposed on the temperature compensation layer 530 and covers the first load layer 540. The second load layer 560 is disposed on the frequency trimming layer 550. The second load layer 560 is disposed above the second end along the vertical direction and close to the first gap along the horizontal direction. The second load layer 560 is in a strip shape and intersects with the first electrode strips 522 to form multiple second overlap portions. The second overlap portions are close to the first gap along the horizontal direction, and the first gap is disposed between the second busbar 523 and the second overlap portions. A thickness of the first load layer 540 is equal to or approximate to a thickness of the second load layer 560.

In some embodiments, a material of the piezoelectric substrate 510 includes but is not limited to one of the following: lithium tantalate and lithium niobate.

In some embodiments, a material of the electrode layer 520 includes but is not limited to one of the following: molybdenum, ruthenium, tungsten, platinum, iridium, aluminum, beryllium, gold, titanium, copper, chromium, magnesium, scandium, and an alloy of any two or more of these materials. It should be noted that the IDT device may have a single-layer structure or a multi-layer structure, for example, the IDT device includes two IDT sublayers, one of which is made of aluminum, and the other one of which is made of tungsten.

In some embodiments, a material of the temperature compensation layer 530 includes but is not limited to one of the following: silicon dioxide and silicon oxyfluoride.

In some embodiments, a material of the frequency trimming layer 550 includes but is not limited to one of the following: silicon nitride, aluminum nitride, silicon oxynitride, aluminum oxide and silicon carbide.

In some embodiments, a material of the first load layer 540 includes but is not limited to at least one of the following: molybdenum, ruthenium, tungsten, platinum, iridium, aluminum, beryllium, gold, titanium, copper, chromium, magnesium and scandium. It should be noted that the first load layer 540 may have a single-layer structure or a multi-layer structure. For example, the first load layer 540 includes two load sublayers, one of which is made of molybdenum, and the other one of which is made of titanium.

In some embodiments, a material of the second load layer 560 includes but is not limited to at least one of the following: molybdenum, ruthenium, tungsten, platinum, iridium, aluminum, beryllium, gold, titanium, copper, chromium, magnesium and scandium. It should be noted that the second load layer 560 may have a single-layer structure or a multi-layer structure.

In some embodiments, the material of the first load layer 540 may be the same as that of the second load layer 560. In some embodiments, the material of the first load layer may be different from that of the second load layer.

In some embodiments, a width of the first load layer 540 is less than a width of the second load layer 560. In some embodiments, a width of a first load layer is equal to or approximate to a width of a second load layer, and a thickness of the first load layer is greater than or less than a thickness of the second load layer. In some embodiments, the width of the first load layer is greater than or less than the width of the second load layer, and the thickness of the first load layer is greater than or less than the thickness of the second load layer. By adjusting size parameters of the first load layer (such as thickness, width) or size parameters of the second load layer (such as thickness, width), a resonance frequency of the corresponding region of the first load layer or a resonance frequency of the corresponding region of the second load layer can be adjusted.

FIG. 19 illustrates a schematic view of a top plane B of the SAW resonance device 500 relative to the cross-section A according to an embodiment of the present disclosure.

Referring to FIG. 19, in some embodiments, the IDT device further includes multiple second electrode strips 524. A third end of each of the second electrode strips 524 is coupled with the second busbar 523, and a fourth end of each of the second electrode strips 524 opposite to the third end along the horizontal direction is close to the first busbar 521. A second gap is disposed between the fourth end and the first busbar 521.

In some embodiments, the first electrode strips 522 are disposed between the first busbar 521 and the second busbar 523, and the second electrode strips 524 are disposed between the first busbar 521 and the second busbar 523. The first electrode strips 522 and the second electrode strips 524 are arranged alternately to each other. FIGS. 20 to 21 illustrate a schematic view of a cross-section C and a cross-section D of the SAW resonance device 500. As shown in FIGS. 20 to 21, adjacent two electrode strips are respectively coupled with the first busbar 521 and the second busbar 523.

In some embodiments, the first load layer 540 is disposed above the fourth end along the vertical direction and close to the second gap along the horizontal direction. The first load layer 540 intersects with the second electrode strips 524 to form multiple fourth overlap portions. The fourth overlap portions are close to the second gap along the horizontal direction, and the second gap is disposed between the first busbar 521 and the fourth overlap portions.

In some embodiments, the second load layer 560 is disposed close to the third end along the horizontal direction and above the second electrode strips 524 along the vertical direction. The second load layer 560 also intersects with the second electrode strips 524 to form multiple third overlap portions. The third overlap portions are close to the third end along the horizontal direction, and the third end is disposed between the third overlap portions and the second busbar 523.

Referring to FIGS. 19 and 20, in some embodiments, the first load layer 540 is further disposed between adjacent first overlap portions and fourth overlap portions to connect adjacent first overlap portions and fourth overlap portions.

Referring to FIGS. 19 and 21, in some embodiments, the second load layer 560 is further disposed between adjacent second overlap portions and third overlap portions to connect adjacent second overlap portions and third overlap portions.

In some embodiments, a region between the first load layer 540 and the second load layer 560 constitutes a first region I, a region between the first busbar 521 and the first load layer 540 constitutes a second region II, a region between the second load layer 560 and the second busbar 523 constitutes a third region III, a region between the first region I and the second region II constitutes a fourth region IV, and a region between the first region I and the third region III constitutes a fifth region V A region where the first busbar 521 is located constitutes a first busbar region (unmarked), and a region where the second busbar 523 is located constitutes a second busbar region (unmarked). In some embodiments, the first load layer 540 is disposed in the fourth region IV, and the second load layer 560 is disposed in the fifth region V

In some embodiments, the fourth region IV is a portion of an overlap region of the first electrode strips 522 and the second electrode strips 524 that is close to the second gap, and the fifth region V is a portion of the overlap region of the first electrode strips 522 and the second electrode strips 524 that is close to the first gap.

Referring to the schematic view of the wave velocity in FIG. 18, the wave velocity in the first region I is lower than that in the second region II, the wave velocity in the first region I is lower than that in the third region III, the wave velocity in the first region I is greater than that in the fourth region IV, the wave velocity in the first region I is greater than that in the fifth region V, the wave velocity in the second region II is equal to or approximate to that in the third region III, and the wave velocity in the fourth region IV is greater than that in the fifth region V

By reducing the wave velocity of the acoustic waves in the fourth region IV and the fifth region V to be lower than the wave velocity in the first region I, the piston mode is excited. In the piston mode, the wave displacement distribution in the first region I remains unchanged in the Oth mode. In the higher-order mode, the wave displacement distribution in the first region I follows integer multiples of a half cycle of a cosine curve, and an integration of the wave displacement distribution in the higher-order mode is 0. Therefore, higher-order acoustic waves in the first region I cannot be excited by electrodes, which suppresses transverse spurious resonance in the higher-order mode.

By introducing the first load layer 540 and the second load layer 560, the transverse spurious resonance at one side of a main resonance peak is suppressed, and a split resonance caused by the first load layer 540 and the second load layer 560 occurs at the other side of the main resonance peak, which forms a split mode. The split resonance is formed by the superposition of two resonances caused by the first load layer 540 and the second load layer 560 respectively. By adjusting the wave velocity in the fourth region IV and the fifth region V, the frequencies of the two spurious resonances are different and two spurious resonances partially cancel out with each other, which can mitigate the split mode and reduce the split spurious resonance in the passband of the filter device produced by the load layers.

FIG. 22 illustrates a schematic view of a wireless communication device 600. As shown in FIG. 22, the wireless communication device 600 includes an RF front-end device 60, a baseband processing device 630 and an antenna 650. A first end of the RF front-end device 610 is coupled with the baseband processing device 630, and a second end of the RF front-end device 610 is coupled with the antenna 650. The RF front-end device 610 includes a first filter device 611, a second filter device 613, a multiplexing device 615, a power amplification device 617 and a low noise amplification device 619. The first filter device 611 is coupled with the power amplification device 617, and the second filter device 613 is electrically coupled with the low noise amplification device 619. The multiplexing device 615 includes at least one transmitting filter device (not shown) and at least one receiving filter device (not shown). The first filter device 611 includes at least one surface acoustic wave resonance device according to any one of preceding embodiments, and the second filter device 613 includes at least one surface acoustic wave resonance device according to any one of preceding embodiments. The at least one transmitting filter device includes at least one surface acoustic wave resonance device according to any one of preceding embodiments, or the at least one receiving filter device includes at least one surface acoustic wave resonance device according to any one of preceding embodiments.

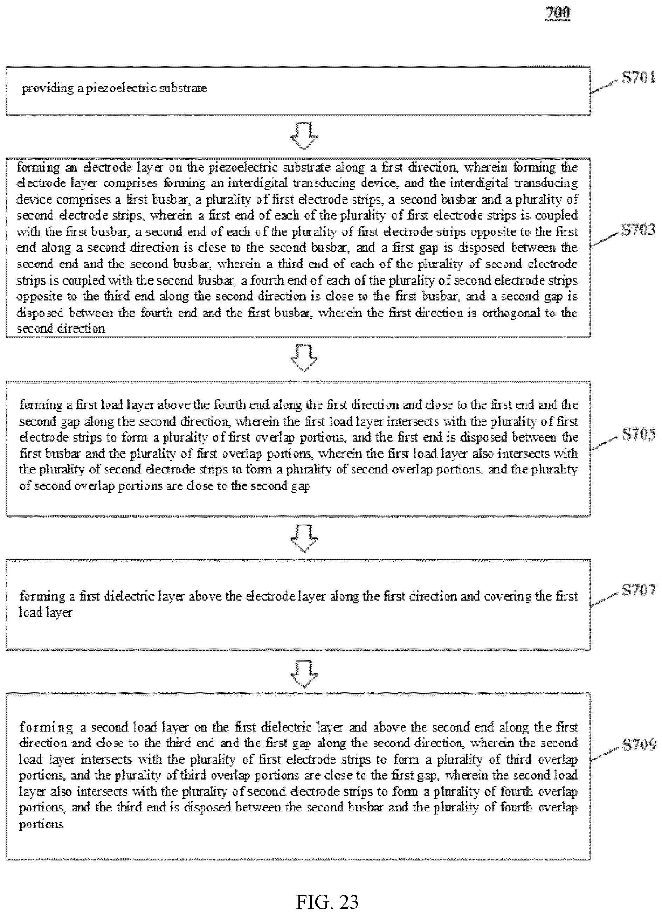

FIG. 23 illustrates a method for forming a SAW resonance device according to a specific embodiment of the present disclosure. However, the present disclosure can also be implemented in other ways different from the specific embodiment described herein, and thus the present disclosure is not limited by the specific embodiment disclosed below.

FIG. 23 illustrates a flowchart of a method 700 for forming a surface acoustic wave resonance device according to an embodiment of the present disclosure.

In some embodiments, the method for forming the surface acoustic wave resonance device includes steps of:
S701: providing a piezoelectric substrate.
S703: forming an electrode layer on the piezoelectric substrate along a first direction. Forming the electrode layer includes forming an interdigital transducing device, and the interdigital transducing device includes a first busbar, multiple first electrode strips, a second busbar and multiple second electrode strips. A first end of each of the first electrode strips is coupled with the first busbar, a second end of each of the first electrode strips opposite to the first end along a second direction is close to the second busbar, and a first gap is disposed between the second end and the second busbar. A third end of each of the second electrode strips is coupled with the second busbar, a fourth end of each of the second electrode strips opposite to the third end along the second direction is close to the first busbar, and a second gap is disposed between the fourth end and the first busbar. The first direction is orthogonal to the second direction.
S705: forming a first load layer above the fourth end along the first direction and close to the first end and the second gap along the second direction. The first load layer intersects with the first electrode strips to form multiple first overlap portions, and the first end is disposed between the first busbar and the first overlap portions. The first load layer also intersects with the second electrode strips to form multiple second overlap portions, and the second overlap portions are close to the second gap.
S707: forming a first dielectric layer above the electrode layer along the first direction and covering the first load layer.
S709: forming a second load layer on the first dielectric layer and above the second end along the first direction and close to the third end and the first gap along the second direction. The second load layer intersects with the first electrode strips to form multiple third overlap portions, and the third overlap portions are close to the first gap. The second load layer also intersects with the second electrode strips to form multiple fourth overlap portions, and the third end is disposed between the second busbar and the fourth overlap portions.

In some embodiments, the method 700 further includes: forming a second dielectric layer on the piezoelectric substrate and covering the electrode layer. The first load layer is disposed on the second dielectric layer, and the first dielectric layer is disposed on the second dielectric layer. In some embodiments, the first dielectric layer is made of a material selected from a group consisting of silicon nitride, aluminum nitride, silicon oxynitride, aluminum oxide and silicon carbide. In some embodiments, the second dielectric layer is made of a material selected from a group consisting of silicon dioxide and silicon oxyfluoride. In some embodiments, the method 700 further includes: forming a third dielectric layer on the second dielectric layer and covering the second load layer, and forming a fourth dielectric layer on the third dielectric layer corresponding to the electrode layer. In some embodiments, the first dielectric layer is made of a material selected from a group consisting of silicon dioxide and silicon oxyfluoride. In some embodiments, the second dielectric layer is made of a material selected from a group consisting of silicon dioxide and silicon oxyfluoride. In some embodiments, the third dielectric layer is made of a material selected from a group consisting of silicon dioxide and silicon oxyfluoride. In some embodiments, the fourth dielectric layer is made of a material selected from a group consisting of silicon nitride, aluminum nitride, silicon oxynitride, aluminum oxide and silicon carbide.

In some embodiments, forming the first load layer includes forming a first load sublayer and forming a second load sublayer on the first load sublayer, and a material of the first load sublayer is different from a material of the second load sublayer.

In some embodiments, forming the second load layer includes forming a third load sublayer and forming a fourth load sublayer on the third load sublayer, and a material of the third load sublayer is different from a material of the fourth load sublayer.

In some embodiments, a first thickness of the first load layer is different from a second thickness of the second load layer.

In some embodiments, a first width of the first load layer is different from a second width of the second load layer.

In some embodiments, the first load layer includes multiple first load portions, and the second load layer includes multiple second load portions.

In some embodiments, the first load layer is in a strip shape, and the second load layer is in a strip shape.

In some embodiments, along the second direction, a first region is disposed between the first load layer and the second load layer, a second region is disposed between the first load layer and the first busbar, a third region is disposed between the second load layer and the second busbar, a fourth region is disposed between the first region and the second region, and a fifth region is disposed between the first region and the third region. The fourth region includes the first load layer, and the fifth region includes the second load layer. A first wave velocity of an acoustic wave in the first region is greater than a second wave velocity of the acoustic wave in the fourth region, and is also greater than a third wave velocity of the acoustic wave in the fifth region, and the second wave velocity is different from the third wave velocity.

It should be noted that the region between the first load layer and the second load layer of the SAW resonance device constitutes the first region, the region where the first load layer is located constitutes the second region at a first side of the first region, and the region where the second load layer is located constitutes the third region at a second side of the first region opposite to the first side. The first load layer and the second load layer are configured to reduce a propagation speed of acoustic waves in the second region and the third region respectively to be lower than the propagation speed of the acoustic waves in the first region. In this state, the SAW resonance device is in a piston mode, in which higher-order transverse spurious resonance is suppressed.

In addition, a first setting parameter of the first load layer (such as relative height, thickness, width) is different from a second setting parameter of the second load layer, and the propagation speeds of the acoustic waves in the second region and the third region are different and corresponding resonance frequencies are different. By reasonably setting the first setting parameter and the second setting parameter, two split resonances generated by the first load layer and the second load layer respectively partially cancel out with each other, which can mitigate split mode produced by the first load layer and the second load layer, and reduce split spurious resonance in a passband of a filter device produced by the load layers.

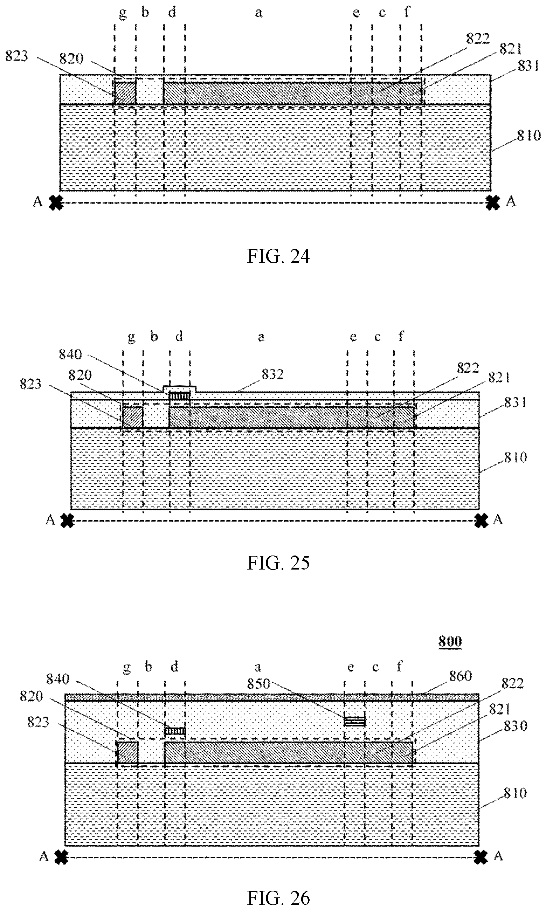

FIGS. 24 to 26 illustrate schematic views showing a method for forming a SAW resonance device according to an embodiment of the present disclosure. However, the present disclosure can also be implemented in other ways different from the specific embodiment described herein, and thus the present disclosure is not limited by the specific embodiment disclosed below.

FIGS. 24 to 26 illustrate schematic views of a cross-section A of a SAW resonance device 800 formed by a method according to an embodiment of the present disclosure.

As shown in FIG. 24, the method for forming the SAW resonance device 800 includes: providing a piezoelectric substrate 810, forming an electrode layer 820 on the piezoelectric substrate 810 along a vertical direction, and forming a first dielectric layer 831 on the piezoelectric substrate 810 and covering the electrode layer 820. Forming the electrode layer includes forming an IDT device. The IDT device includes a first busbar 821, multiple first electrode strips 822 and a second busbar 823. A first end of each of the first electrode strips 822 is coupled with the first busbar 821, a second end of each of the first electrode strips 821 opposite to the first end along a horizontal direction is close to the second busbar 823, and a first gap is disposed between the second end and the second busbar 822.

In some embodiments, a material of the piezoelectric substrate 810 includes but is not limited to one of the following: lithium tantalate and lithium niobate.

In some embodiments, a material of the electrode layer 820 includes but is not limited to one of the following: molybdenum, ruthenium, tungsten, platinum, iridium, aluminum, beryllium, gold, titanium, copper, chromium, magnesium, scandium, and an alloy of any two or more of these materials. It should be noted that the IDT device may have a single-layer structure or a multi-layer structure, for example, the IDT device includes two IDT sublayers, one of which is made of aluminum, and the other one of which is made of tungsten.

In some embodiments, a material of the first dielectric layer 831 includes but is not limited to one of the following: silicon dioxide and silicon oxyfluoride.

As shown in FIG. 25, the method for forming the SAW resonance device 800 further includes forming a first load layer 840 on the first dielectric layer 831 and forming a second dielectric layer 832 on the first dielectric layer 831 and covering the first load layer 840. The first load layer 840 is disposed above the second end along the vertical direction and close to the first gap along the horizontal direction. The first load layer 840 is in a strip shape and intersects with the first electrode strips 822 to form multiple first overlap portions. The first overlap portions are close to the first gap along the horizontal direction, and the first gap is disposed between the second busbar 823 and the first overlap portions.

In some embodiments, a material of the first load layer 840 includes but is not limited to one of the following: molybdenum, ruthenium, tungsten, platinum, iridium, aluminum, beryllium, gold, titanium, copper, chromium, magnesium and scandium. It should be noted that the first load layer 840 may have a single-layer structure or a multi-layer structure. For example, the first load layer 840 includes two load sublayers, one of which is made of molybdenum, and the other one of which is made of titanium.

In some embodiments, a material of the second dielectric layer 832 includes but is not limited to one of the following: silicon dioxide and silicon oxyfluoride.

As shown in FIG. 26, the method for forming the SAW resonance device 800 further includes: forming a second load layer 850 on the second dielectric layer 832. The second load layer 850 is disposed close to the first end along the horizontal direction and above the electrode strips 822 along the vertical direction. The second load layer 850 is in a strip shape and intersects with the first electrode strips 822 to form multiple second overlap portions. The second overlap portions are close to the first end along the horizontal direction, and the first end is disposed between the second overlap portions and the first busbar 821. The method further includes forming a third dielectric layer (unmarked) on the second dielectric layer 832 and covering the second load layer 850, so that forming a temperature compensation layer 830 based on the first dielectric layer 831, the second dielectric layer 832 and the third dielectric layer, and forming a frequency trimming layer 860 on the temperature compensation layer 830.

In some embodiments, a material of the second load layer 850 includes but is not limited to one of the following: molybdenum, ruthenium, tungsten, platinum, iridium, aluminum, beryllium, gold, titanium, copper, chromium, magnesium and scandium. It should be noted that the second load layer 250 may have a single-layer structure or a multi-layer structure.

In some embodiments, the material of the second load layer 850 may be the same as that of the first load layer 840. In some embodiments, the material of the second load layer may be different from that of the first load layer.

In some embodiments, a material of the temperature compensation layer 830 includes but is not limited to one of the following: silicon dioxide and silicon oxyfluoride.

In some embodiments, a material of the frequency trimming layer 860 includes but is not limited to one of the following: silicon nitride, aluminum nitride, silicon oxynitride, aluminum oxide and silicon carbide.

In some embodiments, a region between the first load layer 840 and the second load layer 850 constitutes a resonance intermediate region a, a region between the first load layer 840 and the second busbar 823 constitutes a first gap region b, a region between the second load layer 850 and the first busbar 821 constitutes a second gap region c, a region between the resonance intermediate region a and the first gap region b constitutes a first resonance edge region d, and a region between the resonance intermediate region a and the second gap region c constitutes a second resonance edge region e. The first load layer 840 is disposed in the first resonance edge region d., and the second load layer 850 is disposed in the second resonance edge region e. A region where the first busbar 821 is located constitutes a first busbar region f, and a region where the second busbar 823 is located constitutes a second busbar region g.

In some embodiments, the second load layer 850 is higher than the first load layer 840 along the vertical direction, and there is a first height difference between the first load layer 840 and the second load layer 850. It should be noted that by adjusting the height of the first load layer or the height of the second load layer, a height difference is formed between the first load layer and the second load layer so as to adjust a first resonance frequency of a corresponding region of the first load layer or a second resonance frequency of a corresponding region of the second load layer.

In some embodiments, a thickness of the second load layer 850 is greater than a thickness of the first load layer 840, and a width of the second load layer 850 is equal to or approximate to a width of the first load layer 840. In some embodiments, a wave velocity of an acoustic wave in the first resonance edge region d is lower than a wave velocity of the acoustic wave in the resonance intermediate region a, and the wave velocity of the acoustic wave in the first resonance edge region d is greater than a wave velocity of the acoustic wave in the second resonance edge region e, thereby distinguishing a resonance frequency of the first resonance edge region d from a resonance frequency of the second resonance edge region e. It should be noted that by adjusting parameters of the first load layer (such as thickness, width) or parameters of the second load layer, a resonance frequency of a corresponding region of the first load layer or a resonance frequency of a corresponding region of the second load layer can be adjusted.

By reducing the wave velocity of the acoustic wave in the first resonance edge region d and the second resonance edge region e to be lower than the wave velocity of the acoustic wave in the resonance intermediate region a, the piston mode is excited. In the piston mode, the wave displacement distribution in the resonance intermediate region a remains unchanged in the Oth mode. In the higher-order mode, the wave displacement distribution in the resonance intermediate region a becomes integer multiples of a half cycle of a cosine curve, and an integration of the wave displacement distribution in the higher-order mode is 0. Therefore, higher-order acoustic waves in the resonance intermediate region a cannot be excited by electrodes, which suppresses transverse spurious resonance in the higher-order mode.

By introducing the first load layer 840 and the second load layer 850, a transverse spurious resonance at one side of a main resonance peak is suppressed, and a split resonance caused by the first load layer 840 and the second load layer 850 occurs at the other side of the main resonance peak, which forms a split mode. The split resonance is formed by the superposition of two resonances caused by the first load layer 840 and the second load layer 850 respectively. By adjusting the wave velocity of the acoustic wave in the first resonance edge region d and the second resonance edge region e, the frequencies of the two spurious resonances are different, and two spurious resonances partially cancel out with each other, which can mitigate the split mode and reduce the split spurious resonance in the passband of the filter device produced by the load layers.

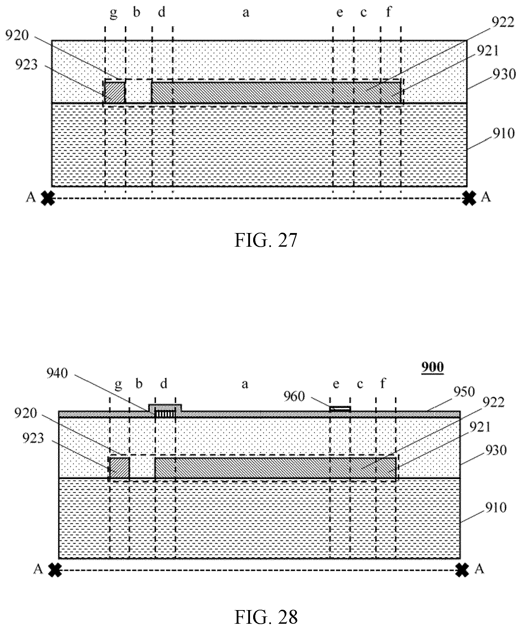

FIGS. 27 to 28 illustrate schematic views showing a method for forming a SAW resonance device according to a specific embodiment of the present disclosure. However, the present disclosure can also be implemented in other ways different from the specific embodiment described herein, and thus the present disclosure is not limited by the specific embodiment disclosed below.

FIGS. 27 to 28 illustrate schematic views of a cross-section A of a SAW resonance device 900 formed by a method according to an embodiment of the present disclosure.

As shown in FIG. 27, the method for forming the SAW resonance device 900 includes providing a piezoelectric substrate 910, forming an electrode layer 920 on the piezoelectric substrate 910 along a vertical direction, and forming a temperature compensation layer 931 on the piezoelectric substrate 910 and covering the electrode layer 920. Forming the electrode layer 920 includes forming an IDT device. The IDT device includes a first busbar 921, multiple first electrode strips 922 and a second busbar 923. A first end of each of the first electrode strips 922 is coupled with the first busbar 921, a second end of each of the first electrode strips 921 opposite to the first end along a horizontal direction is close to the second busbar 923, and a first gap is disposed between the second end and the second busbar 922.

In some embodiments, a material of the piezoelectric substrate 910 includes but is not limited to one of the following: lithium tantalate and lithium niobate.

In some embodiments, a material of the electrode layer 920 includes but is not limited to one of the following: molybdenum, ruthenium, tungsten, platinum, iridium, aluminum, beryllium, gold, titanium, copper, chromium, magnesium, scandium, and an alloy of any two or more of these materials. It should be noted that the IDT device may have a single-layer structure or a multi-layer structure, for example, the IDT device includes two IDT sublayers, one of which is made of aluminum, and the other one of which is made of tungsten.

In some embodiments, a material of the temperature compensation layer 931 includes but is not limited to one of the following: silicon dioxide and silicon oxyfluoride.

As shown in FIG. 28, the method for forming the SAW resonance device 900 further includes: forming a first load layer 940 on the temperature compensation layer 930, forming a frequency trimming layer 950 on the temperature compensation layer 930 and covering the first load layer 940, and forming a second load layer 960 on the frequency trimming layer 950. The first load layer 940 is disposed above the second end along the vertical direction and close to the first gap along the horizontal direction. The first load layer 940 is in a strip shape and intersects with the first electrode strips 922 to form multiple first overlap portions. The first overlap portions are close to the first gap along the horizontal direction, and the first gap is disposed between the second busbar 923 and the first overlap portions. The second load layer 960 is disposed close to the first end along the horizontal direction and above the electrode strips 922 along the vertical direction. The second load layer 960 is in a strip shape and intersects with the first electrode strips 922 to form multiple second overlap portions. The second overlap portions are close to the first end along the horizontal direction, and the first end is disposed between the second overlap portions and the first busbar 921.

In some embodiments, a material of the first load layer 940 includes but is not limited to one of the following: molybdenum, ruthenium, tungsten, platinum, iridium, aluminum, beryllium, gold, titanium, copper, chromium, magnesium and scandium. It should be noted that the first load layer 940 may have a single-layer structure or a multi-layer structure. For example, the first load layer 940 includes two load sublayers, one of which is made of molybdenum, and the other one of which is made of titanium.

In some embodiments, a material of the frequency trimming layer 950 includes but is not limited to one of the following: silicon nitride, aluminum nitride, silicon oxynitride, aluminum oxide and silicon carbide.

In some embodiments, a material of the second load layer 960 includes but is not limited to at least one of the following: molybdenum, ruthenium, tungsten, platinum, iridium, aluminum, beryllium, gold, titanium, copper, chromium, magnesium and scandium. It should be noted that the second load layer 960 may have a single-layer structure or a multi-layer structure.

In some embodiments, the material of the second load layer 960 may be the same as that of the first load layer 940. In some embodiments, the material of the second load layer may be different from that of the first load layer.

In some embodiments, a region between the first load layer 940 and the second load layer 960 constitutes a resonance intermediate region a, a region between the first load layer 940 and the second busbar 923 constitutes a first gap region b, a region between the second load layer 960 and the first busbar 921 constitutes a second gap region c, a region between the resonance intermediate region a and the first gap region b constitutes a first resonance edge region d, and a region between the resonance intermediate region a and the second gap region c constitutes a second resonance edge region e. The first load layer 940 is disposed in the first resonance edge region d, and the second load layer 960 is disposed in the second resonance edge region e. A region where the first busbar 921 is located constitutes a first busbar region f, and a region where the second busbar 923 is located constitutes a second busbar region g.

In some embodiments, a thickness of the second load layer 960 is less than a thickness of the first load layer 940, and a width of the second load layer 960 is equal to or approximate to a width of the first load layer 940. In some embodiments, a wave velocity of an acoustic wave in the second resonance edge region e is lower than a wave velocity of the acoustic wave in the resonance intermediate region a, and a wave velocity of the acoustic wave in the first resonance edge region d is lower than the wave velocity of the acoustic wave in the second resonance edge region e, thereby distinguishing a resonance frequency of the first resonance edge region d from a resonance frequency of the second resonance edge region e. It should be noted that by adjusting parameters of the first load layer (such as thickness, width) or parameters of the second load layer, a resonance frequency of a corresponding region of the first load layer or a resonance frequency of a corresponding region of the second load layer can be adjusted.

By reducing the wave velocity of the acoustic wave in the first resonance edge region d and the second resonance edge region e to be lower than the wave velocity of the acoustic wave in the resonance intermediate region a, the piston mode is excited. In the piston mode, the wave displacement distribution in the resonance intermediate region a remains unchanged in the Oth mode. In the higher-order mode, the wave displacement distribution in the resonance intermediate region a becomes integer multiples of a half cycle of a cosine curve, and an integration of the wave displacement distribution in the higher-order mode is 0. Therefore, higher-order acoustic waves in the resonance intermediate region a cannot be excited by electrodes, which suppresses transverse spurious resonance in the higher-order mode.

By introducing the first load layer 940 and the second load layer 960, a transverse spurious resonance at one side of a main resonance peak is suppressed, and a split resonance caused by the first load layer 940 and the second load layer 960 occurs at the other side of the main resonance peak, which forms a split mode. The split resonance is formed by the superposition of two resonances caused by the first load layer 940 and the second load layer 960 respectively. By adjusting the wave velocity of the acoustic wave in the first resonance edge region d and the second resonance edge region e, the frequencies of the two spurious resonances are different, and two spurious resonances partially cancel out with each other, which can mitigate the spurious resonance and the split mode, and reduce the split spurious resonance in the passband of the filter device produced by the load layers.

It should be noted that a region between a first load layer and a second load layer of the SAW resonance device constitutes a first region, a region where the first load layer is located constitutes a second region at a first side of the first region, a region where the second load layer is located constitutes a third region at a second side of the first region opposite to the first side. The first load layer and the second load layer are configured to reduce a propagation speed of acoustic waves in the second region and the third region respectively to be lower than the propagation speed of the acoustic waves in the first region. In this state, the SAW resonance device is in a piston mode, which can suppress higher-order transverse spurious resonance.

In addition, a first setting parameter of the first load layer (such as relative height, thickness, width) is different from a second setting parameter of the second load layer, and the propagation speeds of acoustic waves in the second region and the third region are different and corresponding resonance frequencies are different. By reasonably setting the first setting parameter and the second setting parameter, two split resonances generated by the first load layer and the second load layer respectively partially cancel out with each other, which can mitigate split mode produced by the first load layer and the second load layer, and reduce split spurious resonance in a passband of a filter device produced by the load layers..

It should be understood that examples and embodiments herein are only exemplary, and any changes and modifications may be made without departing from the scope of the present disclosure.

## Claims

1. A surface acoustic wave resonance device, comprising:
a piezoelectric substrate;
an electrode layer disposed on the piezoelectric substrate along a first direction, wherein the electrode layer comprises an interdigital transducing device, and the interdigital transducing device comprises a first busbar, a plurality of first electrode strips, a second busbar and a plurality of second electrode strips, wherein a first end of each of the plurality of first electrode strips is coupled with the first busbar, a second end of each of the plurality of first electrode strips opposite to the first end along a second direction is close to the second busbar, and a first gap is disposed between the second end and the second busbar, wherein a third end of each of the plurality of second electrode strips is coupled with the second busbar, a fourth end of each of the plurality of second electrode strips opposite to the third end along the second direction is close to the first busbar, and a second gap is disposed between the fourth end and the first busbar;
a first load layer disposed above the fourth end along the first direction and close to the first end and the second gap along the second direction, wherein the first load layer intersects with the plurality of first electrode strips to form a plurality of first overlap portions, and the first end is disposed between the first busbar and the plurality of first overlap portions, wherein the first load layer also intersects with the plurality of second electrode strips to form a plurality of second overlap portions, and the plurality of second overlap portions are close to the second gap;
a first dielectric layer disposed above the electrode layer along the first direction and covering the first load layer; and
a second load layer disposed on the first dielectric layer and above the second end along the first direction and disposed close to the third end and the first gap along the second direction, wherein the second load layer intersects with the plurality of first electrode strips to form a plurality of third overlap portions, and the plurality of third overlap portions are close to the first gap, wherein the second load layer also intersects with the plurality of second electrode strips to form a plurality of fourth overlap portions, and the third end is disposed between the second busbar and the plurality of fourth overlap portions.

2. The surface acoustic wave resonance device according to claim 1, further comprising a second dielectric layer disposed on the piezoelectric substrate along the first direction and covering the electrode layer, wherein the second dielectric layer comprises the first dielectric layer, the first load layer is disposed in the second dielectric layer, and the second load layer is disposed in the second dielectric layer.

3. The surface acoustic wave resonance device according to claim 2, wherein the first dielectric layer is made of a material selected from a group consisting of silicon dioxide and silicon oxyfluoride.

4. The surface acoustic wave resonance device according to claim 2, wherein the second dielectric layer is made of a material selected from a group consisting of silicon dioxide and silicon oxyfluoride.

5. The surface acoustic wave resonance device according to claim 2, further comprising a third dielectric layer disposed on the second dielectric layer corresponding to the electrode layer.

6. The surface acoustic wave resonance device according to claim 5, wherein the third dielectric layer is made of a material selected from a group consisting of silicon nitride, aluminum nitride, silicon oxynitride, aluminum oxide and silicon carbide.

7. The surface acoustic wave resonance device according to claim 1, further comprising a fourth dielectric layer disposed on the piezoelectric substrate along the first direction and covering the electrode layer, wherein the first load layer is disposed on the fourth dielectric layer, and the first dielectric layer is disposed on the fourth dielectric layer corresponding to the electrode layer.

8. The surface acoustic wave resonance device according to claim 7, wherein the fourth dielectric layer is made of a material selected from a group consisting of silicon dioxide and silicon oxyfluoride.

9. The surface acoustic wave resonance device according to claim 7, wherein the first dielectric layer is made of a material selected from a group consisting of silicon nitride, aluminum nitride, silicon oxynitride, aluminum oxide and silicon carbide.

10. The surface acoustic wave resonance device according to claim 1, wherein the first load layer is made of a material selected from a group consisting of molybdenum, ruthenium, tungsten, platinum, iridium, aluminum, beryllium, gold, titanium, copper, chromium, magnesium and scandium.

11. The surface acoustic wave resonance device according to claim 1, wherein the first load layer comprises a first load sublayer and a second load sublayer disposed on the first load sublayer, and a material of the first load sublayer is different from a material of the second load sublayer.

12. The surface acoustic wave resonance device according to claim 1, wherein the second load layer is made of a material selected from a group consisting of molybdenum, ruthenium, tungsten, platinum, iridium, aluminum, beryllium, gold, titanium, copper, chromium, magnesium and scandium.

13. The surface acoustic wave resonance device according to claim 1, wherein the second load layer comprises a third load sublayer and a fourth load sublayer disposed on the third load sublayer, and a material of the third load sublayer is different from a material of the fourth load sublayer.

14. The surface acoustic wave resonance device according to claim 1, wherein a first thickness of the first load layer is different from a second thickness of the second load layer.

15. The surface acoustic wave resonance device according to claim 1, wherein a first width of the first load layer is different from a second width of the second load layer.

16. The surface acoustic wave resonance device according to claim 1, wherein the first load layer comprises a plurality of first load portions, and the second load layer comprises a plurality of second load portions.

17. The surface acoustic wave resonance device according to claim 1, wherein the first load layer is in a strip shape, and the second load layer is in a strip shape.

18. The surface acoustic wave resonance device according to claim 1, wherein along the second direction, a first region is disposed between the first load layer and the second load layer, a second region is disposed between the first load layer and the first busbar, a third region is disposed between the second load layer and the second busbar, a fourth region is disposed between the first region and the second region, and a fifth region is disposed between the first region and the third region, wherein the fourth region comprises the first load layer, and the fifth region comprises the second load layer, wherein a first wave velocity of an acoustic wave in the first region is greater than a second wave velocity of the acoustic wave in the fourth region, and is also greater than a third wave velocity of the acoustic wave in the fifth region, and the second wave velocity is different from the third wave velocity.

19. A surface acoustic wave resonance device, comprising:
a piezoelectric substrate;
an electrode layer disposed on the piezoelectric substrate along a first direction, wherein the electrode layer comprises an interdigital transducing device, and the interdigital transducing device comprises a first busbar portion, a second busbar portion and an interdigital portion disposed between the first busbar portion and the second busbar portion along a second direction;
a first load layer disposed above the interdigital portion along the first direction and close to the first busbar portion along the second direction;
a first dielectric layer disposed above the electrode layer along the first direction and covering the first load layer; and
a second load layer disposed on the first dielectric layer along the first direction and close to the second busbar portion along the second direction;
wherein a first region is disposed between the first load layer and the second load layer along the second direction, a second region is disposed between the first busbar portion and the first load layer along the second direction, a third region is disposed between the second busbar portion and the second load layer along the second direction, a fourth region is disposed between the first region and the second region along the second direction, and a fifth region is disposed between the first region and the third region along the second direction, wherein the first load layer is disposed in the fourth region, and the second load layer is disposed in the fifth region, wherein a first wave velocity of an acoustic wave in the first region is greater than a second wave velocity of the acoustic wave in the fourth region, and is also greater than a third wave velocity of the acoustic wave in the fifth region, and the second wave velocity is different from the third wave velocity.

20. The surface acoustic wave resonance device according to claim 19, further comprising a second dielectric layer disposed on the piezoelectric substrate along the first direction and covering the electrode layer, wherein the second dielectric layer comprises the first dielectric layer, the first load layer is disposed in the second dielectric layer, and the second load layer is disposed in the second dielectric layer.

21. The surface acoustic wave resonance device according to claim 20, wherein the first dielectric layer is made of a material selected from a group consisting of silicon dioxide and silicon oxyfluoride.

22. The surface acoustic wave resonance device according to claim 20, wherein the second dielectric layer is made of a material selected from a group consisting of silicon dioxide and silicon oxyfluoride.

23. The surface acoustic wave resonance device according to claim 20, further comprising a third dielectric layer disposed on the second dielectric layer corresponding to the electrode layer.

24. The surface acoustic wave resonance device according to claim 23, wherein the third dielectric layer is made of a material selected from a group consisting of silicon nitride, aluminum nitride, silicon oxynitride, aluminum oxide and silicon carbide.

25. The surface acoustic wave resonance device according to claim 19, further comprising a fourth dielectric layer disposed on the piezoelectric substrate along the first direction and covering the electrode layer, wherein the first load layer is disposed on the fourth dielectric layer, and the first dielectric layer is disposed on the fourth dielectric layer corresponding to the electrode layer.

26. The surface acoustic wave resonance device according to claim 25, wherein the fourth dielectric layer is made of a material selected from a group consisting of silicon dioxide and silicon oxyfluoride.

27. The surface acoustic wave resonance device according to claim 25, wherein the first dielectric layer is made of a material selected from a group consisting of silicon nitride, aluminum nitride, silicon oxynitride, aluminum oxide and silicon carbide.

28. The surface acoustic wave resonance device according to claim 19, wherein the first load layer is made of a material selected from a group consisting of molybdenum, ruthenium, tungsten, platinum, iridium, aluminum, beryllium, gold, titanium, copper, chromium, magnesium and scandium.

29. The surface acoustic wave resonance device according to claim 19, wherein the first load layer comprises a first load sublayer and a second load sublayer disposed on the first load sublayer, and a material of the first load sublayer is different from a material of the second load sublayer.

30. The surface acoustic wave resonance device according to claim 19, wherein the second load layer is made of a material selected from a group consisting of molybdenum, ruthenium, tungsten, platinum, iridium, aluminum, beryllium, gold, titanium, copper, chromium, magnesium and scandium.

31. The surface acoustic wave resonance device according to claim 19, wherein the second load layer comprises a third load sublayer and a fourth load sublayer disposed on the third load sublayer, and a material of the third load sublayer is different from a material of the fourth load sublayer.

32. The surface acoustic wave resonance device according to claim 19, wherein a first thickness of the first load layer is different from a second thickness of the second load layer.

33. The surface acoustic wave resonance device according to claim 19, wherein a first width of the first load layer is different from a second width of the second load layer.

34. The surface acoustic wave resonance device according to claim 19, wherein the first load layer comprises a plurality of first load portions, and the second load layer comprises a plurality of second load portions.

35. The surface acoustic wave resonance device according to claim 19, wherein the first load layer is in a strip shape, and the second load layer is in a strip shape.

36. A filter device, comprising at least one surface acoustic wave resonance device according to any one of claims 1 to 35.

37. A radio frequency front-end device, comprising a power amplification device and at least one filter device according to claim 36, wherein the power amplification device is coupled with the filter device.

38. A radio frequency front-end device, comprising a low noise amplification device and at least one filter device according to claim 36, wherein the low noise amplification device is coupled with the filter device.

39. A radio frequency front-end device, comprising a multiplexing device, wherein the multiplexing device comprises at least one filter device according to claim 36.

40. A method for forming a surface acoustic wave resonance device, comprising:
providing a piezoelectric substrate;
forming an electrode layer on the piezoelectric substrate along a first direction, wherein forming the electrode layer comprises forming an interdigital transducing device, and the interdigital transducing device comprises a first busbar, a plurality of first electrode strips, a second busbar and a plurality of second electrode strips, wherein a first end of each of the plurality of first electrode strips is coupled with the first busbar, a second end of each of the plurality of first electrode strips opposite to the first end along a second direction is close to the second busbar, and a first gap is disposed between the second end and the second busbar, wherein a third end of each of the plurality of second electrode strips is coupled with the second busbar, a fourth end of each of the plurality of second electrode strips opposite to the third end along the second direction is close to the first busbar, and a second gap is disposed between the fourth end and the first busbar;
forming a first load layer above the fourth end along the first direction and close to the first end and the second gap along the second direction, wherein the first load layer intersects with the plurality of first electrode strips to form a plurality of first overlap portions, and the first end is disposed between the first busbar and the plurality of first overlap portions, wherein the first load layer also intersects with the plurality of second electrode strips to form a plurality of second overlap portions, and the plurality of second overlap portions are close to the second gap;
forming a first dielectric layer above the electrode layer along the first direction and covering the first load layer; and
forming a second load layer on the first dielectric layer and above the second end along the first direction and close to the third end and the first gap along the second direction, wherein the second load layer intersects with the plurality of first electrode strips to form a plurality of third overlap portions, and the plurality of third overlap portions are close to the first gap, wherein the second load layer also intersects with the plurality of second electrode strips to form a plurality of fourth overlap portions, and the third end is disposed between the second busbar and the plurality of fourth overlap portions.

41. The method according to claim 40, further comprising: forming a second dielectric layer on the piezoelectric substrate and covering the electrode layer, wherein the first load layer is disposed on the second dielectric layer, and the first dielectric layer is disposed on the second dielectric layer.

42. The method according to claim 41, wherein the first dielectric layer is made of a material selected from a group consisting of silicon nitride, aluminum nitride, silicon oxynitride, aluminum oxide and silicon carbide.

43. The method according to claim 41, wherein the second dielectric layer is made of a material selected from a group consisting of silicon dioxide and silicon oxyfluoride.

44. The method according to claim 41, further comprising: forming a third dielectric layer on the second dielectric layer and covering the second load layer, and forming a fourth dielectric layer on the third dielectric layer corresponding to the electrode layer.

45. The method according to claim 44, wherein the first dielectric layer is made of a material selected from a group consisting of silicon dioxide and silicon oxyfluoride.

46. The method according to claim 44, wherein the second dielectric layer is made of a material selected from a group consisting of silicon dioxide and silicon oxyfluoride.

47. The method according to claim 44, wherein the third dielectric layer is made of a material selected from a group consisting of silicon dioxide and silicon oxyfluoride.

48. The method according to claim 44, wherein the fourth dielectric layer is made of a material selected from a group consisting of silicon nitride, aluminum nitride, silicon oxynitride, aluminum oxide and silicon carbide.

49. The method according to claim 40, wherein forming the first load layer comprises forming a first load sublayer and forming a second load sublayer on the first load sublayer, and a material of the first load sublayer is different from a material of the second load sublayer.

50. The method according to claim 40, wherein forming the second load layer comprises forming a third load sublayer and forming a fourth load sublayer on the third load sublayer, and a material of the third load sublayer is different from a material of the fourth load sublayer.

51. The method according to claim 40, wherein a first thickness of the first load layer is different from a second thickness of the second load layer.

52. The method according to claim 40, wherein a first width of the first load layer is different from a second width of the second load layer.

53. The method according to claim 40, wherein the first load layer comprises a plurality of first load portions, and the second load layer comprises a plurality of second load portions.

54. The method according to claim 40, wherein the first load layer is in a strip shape, and the second load layer is in a strip shape.

55. The method according to claim 40, wherein along the second direction, a first region is disposed between the first load layer and the second load layer, a second region is disposed between the first load layer and the first busbar, a third region is disposed between the second load layer and the second busbar, a fourth region is disposed between the first region and the second region, and a fifth region is disposed between the first region and the third region, wherein the fourth region comprises the first load layer, and the fifth region comprises the second load layer, wherein a first wave velocity of an acoustic wave in the first region is greater than a second wave velocity of the acoustic wave in the fourth region, and is also greater than a third wave velocity of the acoustic wave in the fifth region, and the second wave velocity is different from the third wave velocity.
